(19) Europäisches Patentamt
European Patent Office
Office européen des brevets

(11) **EP 2 071 278 A1**

(12) **EUROPEAN PATENT APPLICATION**
published in accordance with Art. 153(4) EPC

(43) Date of publication:
**17.06.2009 Bulletin 2009/25**

(21) Application number: **07807732.8**

(22) Date of filing: **21.09.2007**

(51) Int Cl.:
***G01B 11/24*** *(2006.01)* ***B23K 1/00*** *(2006.01)*
***G01N 21/956*** *(2006.01)* ***H05K 3/34*** *(2006.01)*

(86) International application number:
**PCT/JP2007/068400**

(87) International publication number:
**WO 2008/035765 (27.03.2008 Gazette 2008/13)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **21.09.2006 JP 2006255485**
**22.09.2006 JP 2006256910**

(71) Applicant: **I-Pulse Kabushiki Kaisha**
**Hamamatsu-shi, Shizuoka 431-2103 (JP)**

(72) Inventors:
- **KAKUDA, Yoshihisa**
  **Hamamatsu-shi, Shizuoka 431-2103 (JP)**
- **NAKASHIMA, Tsutomu**
  **Hamamatsu-shi, Shizuoka 431-2103 (JP)**

(74) Representative: **Müller-Boré & Partner**
**Patentanwälte**
**Grafinger Strasse 2**
**81671 München (DE)**

(54) **INSPECTING APPARATUS**

(57) The shape of a cream solder is accurately detected, irrespective of a cream solder composition. An illumination setting section (95b) sets the intensity of infrared light radiated by an illuminating device (5), in accordance with the cream solder composition. An photographing device (6) irradiates a board applied with the cream solder with the infrared light having the light intensity set by the illuminating device (5). The photographing device (6) images the board irradiated with the infrared light by the illuminating device (5). As a result, an image including an image of light reflected from a surface of the board can be acquired.

FIG. 3

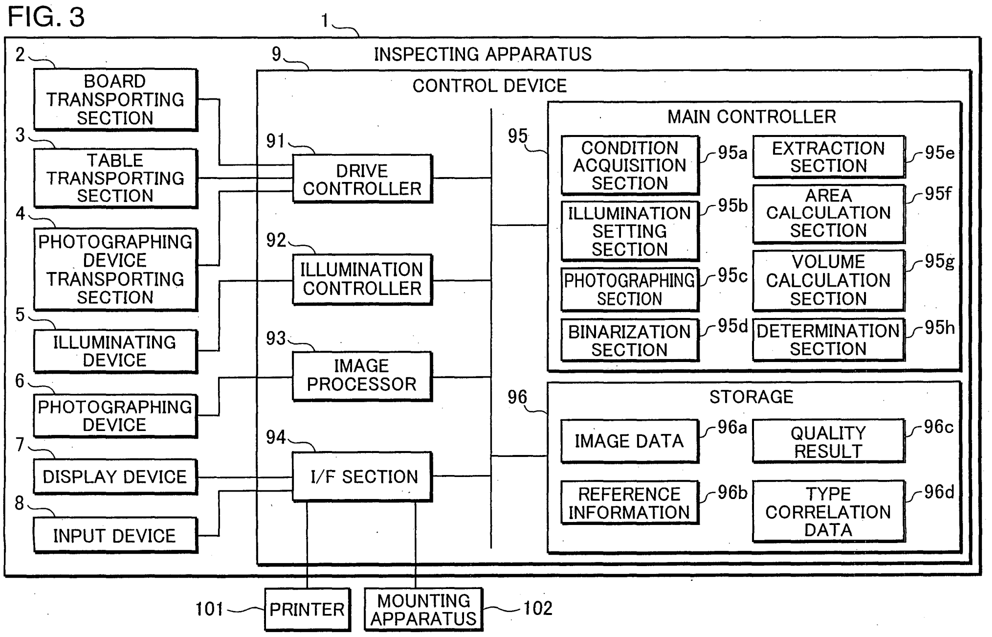


EP 2 071 278 A1

## Description

Technical Field

The present invention relates to an inspecting apparatus for inspecting the condition of a cream solder applied to a board.

Background Art

An inspecting apparatus for inspecting the condition of a solder has been conventionally developed in order to stabilize the quality of a board mounted with an electronic component.

For example, Japanese Unexamined Patent Publication No. H9-89536 discloses a method for inspecting a solder formed between a board and a polyimide board equipped with a semiconductor device. This method radiates a light beam containing a wavelength of infrared region to the board, uses a camera to image reflected light of the wavelength of the infrared region that penetrates through the polyimide board and reflects on a solder surface, subjects the obtained image signal data to AD conversion to acquire a grayscale image signal, and detects the condition of the solder, such as particularly the presence or absence of defective wetting or a bridge, by measuring the dimension of a predetermined region consisting of pixels larger than a previously-set concentration value. Disclosure of the Invention

The electronic component is mounted by applying a cream solder on the board, installing the electronic component in a predetermined position of the board applied with the cream solder, and reflowing the board equipped with the electronic component. When inspecting the condition of the cream solder prior to the installation of the electronic equipment and after the application of the cream solder, waste of the electronic component can be prevented in the even to a failure in the condition of the cream solder, improving the yield.

What is considered to realize this is to apply a conventional method for radiating infrared light onto the polyimide board after bonding or reflow, to the inspecting apparatus or inspecting method. Specifically, the condition of the cream solder can be inspected by radiating the infrared light from above the board applied with the cream solder and detecting the light reflected from the cream solder. Specifically, detection of the light reflected from the surface of the cream solder allows inspection of the outer shape of the cream solder on the board, and detection of the light penetrating through the cream solder and reflected from a metal pad section on the board allows inspection of the condition of the inside of the cream solder.

However, because the ingredients and blend ratio thereof vary according to the type of solder, the light intensity of the reflected light from the surface of the solder or board also varies. For this reason, the condition of the shape or inside of the solder cannot be detected accurately.

Moreover, the characteristics of a cream solder or infrared LED change with time, and consequently the light intensity of the reflected from the surface of the board changes as well. In the case of the cream solder, for example, when exposed to the external air, solidification of the surface or other characteristic change occurs with lapse of time. This is because, out of the constituents of the cream solder, that is, out of flux that contains a polymer component and solder powder, the flux deteriorates, which consequently scatters and attenuates infrared light penetrating through the flux. In the case of the infrared LED, the intensity of infrared light to be outputted changes with lapse of time. As a result, the condition of the inside of the solder cannot be detected accurately.

The invention of the present application therefore has been contrived in view of the above problems, and an object of the present invention is to provide an inspecting apparatus that is capable of detecting the condition of a cream solder, irrespective of a cream solder composition or the like.

In order to solve the problems described above, an inspecting apparatus according to the present invention has: illuminator for irradiating a board applied with a cream solder with infrared light of a predetermined intensity; photographer for photographing the board irradiated with the infrared light; detector for detecting the shape of the cream solder based on the image obtained by the photographer; and setter for setting the intensity of the infrared light radiated by the illuminator, in accordance with a composition of the cream solder.

Another inspecting apparatus according to the present invention has: illuminator for irradiating a board applied with a cream solder with infrared light of a predetermined intensity; photographer for photographing the board irradiated with the infrared light; binarizer for binarizing the image obtained by the photographer by means of a brightness of a predetermined threshold; detector for detecting the shape of the cream solder based on the binarized image obtained by the binarizer; detector for detecting the shape of the cream solder based on the binarized image obtained by the binarizer; and setter for setting the threshold determined in the binarizer in accordance with the cream solder composition.

Another inspecting apparatus according to the present invention has: illuminator for irradiating a board applied with a cream solder with infrared light of a predetermined intensity; photographer for photographing the board irradiated with the infrared light; detector for detecting the shape of the cream solder based on the image obtained by the photographer; and first setter for setting the intensity of the infrared light radiated by the illuminator, in accordance with temporal change of at least either the illuminator or the cream solder.

In addition, another inspecting apparatus according to the present invention has: illuminator for irradiating a board applied with a cream solder with infrared light of a predetermined intensity; photographer for photographing the board irradiated with the infrared light; binarizer for binarizing the image obtained by the photographer by means of a brightness of a predetermined threshold; detector for detecting the shape of the cream solder based on the binarized image obtained by the binarizer; and setter for setting the threshold determined in the binarizer, in accordance with temporal change of at least either the illuminator or the cream solder.

According to the present invention, the infrared light having the intensity set in accordance with the cream solder composition is radiated to the board applied with the solder, and the board irradiated with the infrared light is photographed, whereby the shape of the cream solder can be detected accurately, irrespective of the type of the cream solder.

On the other hand, infrared light having an intensity set in accordance with temporal change of the illuminator or the cream solder is radiated to the board applied with the solder, and the board irradiated with the infrared light is photographed, whereby the shape of the cream solder applied on the board can be detected accurately, irrespective of the temporal change of the illuminator or the cream solder.

Brief Description of the Drawings

[Fig. 1] Fig. 1 is a front view showing the exterior of an inspecting apparatus of the present invention;
[Fig. 2] Fig. 2 is a plan view showing an internal constitution of the inspecting apparatus of the present invention;
[Fig. 3] Fig. 3 is a block diagram showing a constitution of a control system of the inspecting apparatus of the present invention;
[Fig. 4] Fig. 4 is a diagram schematically showing an photographing unit;
[Fig. 5] Fig. 5 is a diagram schematically showing a constitution of a cream solder;
[Fig. 6] Fig. 6A is an image of reflected light obtained when radiating infrared light to a board applied with the cream solder with a screen having a thickness of 50 $\mu$m, and Fig. 6B is a graph showing a light intensity distribution obtained in Fig. 6A;
[Fig. 7] Fig. 7A is an image of reflected light obtained when radiating infrared light to a board applied with the cream solder with a screen having a thickness of 70 $\mu$m, and Fig. 7B is a graph showing a light intensity distribution obtained in Fig. 7A;
[Fig. 8] Fig. 8A is an image of reflected light obtained when radiating infrared light to a board applied with the cream solder with a screen having a thickness of 100 $\mu$m, and Fig. 8B is a graph showing a light intensity distribution obtained in Fig. 8A;
[Fig. 9] Figs. 9A to C are each a diagram schematically showing a vertical cross section of the cream solder;
[Fig. 10] Figs. 10A to C are each a diagram schematically showing an image of reflected light obtained when irradiating Figs. 9A to C with infrared light of the same intensity;
[Fig. 11] Fig. 11 is a diagram showing the relationship between the thickness of the cream solder and the brightness of pixels;
[Fig. 12] Fig. 12 is a diagram showing images of reflected light obtained when the intensity of the infrared light is changed;
[Fig. 13] Fig. 13 is a diagram for explaining how the infrared light proceeds in the cream solder;
[Fig. 14] Fig. 14 is a flowchart showing an inspection operation;
[Fig. 15] Fig. 15 is a diagram showing the relationships between the types of cream solders and the intensities of the infrared light to be radiated;
[Fig. 16] Fig. 16 is a flowchart showing first photographing processing;
[Fig. 17] Fig. 17 is a diagram schematically showing binarized photographic data;
[Fig. 18] Fig. 18 is a flowchart showing a second image process;
[Fig. 19] Fig. 19 is a flowchart showing a third image process;
[Fig. 20] Fig. 20 is a flowchart showing quality determination process;
[Fig. 21] Fig. 21 is a block diagram showing a constitution of a control system of an inspecting apparatus according to a second embodiment of the present invention;
[Fig. 22] Fig. 22 is a characteristic diagram of an example of solder correlation data; and
[Fig. 23] Fig. 23 is a characteristic diagram of an example of LED correlation data.

Best Mode for Carrying Out the Invention

Embodiments of the present invention are described hereinafter in detail with reference to the drawings.

[First Embodiment]

(Constitution of Inspecting Apparatus)

As shown in Figs. 1 and 2, an inspecting apparatus 1 according to the present embodiment is entirely covered with a substantially rectangular solid-shaped cover 10, and the inside of the cover 10 has a base 11 formed into a hollow and substantially rectangular solid-shape. This inspecting apparatus 1 has a board transporting section 2, table transporting section 3, photographing device transporting section 4, illuminating device, 5, photographing device 6, display device 7, input device 8, and control device 9, as showing Figs. 1 to 3.

The board transporting section 2 provided on the base 11, as shown in Fig. 2, transports a print board P (to be referred to as "board P" hereinafter) as an object to be inspected, and is configured by three constituents, each having a pair of belt conveyors and disposed in an X-axis direction. Specifically, conveying in/out sections 2A, 2C that respectively have pairs of belt conveyors 20A and 21A, 20C and 21C are provided in predetermined areas on either side of the inspecting apparatus 1 in a transportation direction, and a movable section 2B having a pair of belt conveyors 20B, 21B on a table 30 described hereinafter is provided between these conveying in/out sections 2A, 2C. Note in the present embodiment that the transportation direction of the board P (the traverse direction in Fig. 2) represents the X-axis direction, and a direction perpendicular to the X-axis on a horizontal plane a Y-axis direction (the vertical direction in Fig. 2).

In the conveying in/out section 2A, 2C, the front conveyors 20A, 20C are provided in a fixed manner on the base 11, whereas the rear conveyors 21A, 21C are made movable in the Y-axis direction. Moving the rear conveyors 21A, 21C by driving a motor (not shown) allows the adjustment of the space between the conveyors in relation to the size of the board P.

In the movable section 2B the pair of conveyors 20B, 21B are provided on the table 30 movable in the Y-axis direction, and the front conveyor 20B is fixed to the table 30, whereas the rear conveyor 21B is movably supported by the table 30 in the Y-axis direction. By moving the rear conveyor 21B with the motor (not shown), the space between the conveyors 20B, 21B changes to correspond to changes in size of the board P.

Each of the conveyors 20A, 21A, 20B, 21B, 20C and 21C is mounted such that a transportation belt (not shown) is stretched around a pulley. When the conveyors 20B and 21B of the movable section 2B is in positions corresponding to the positions of the other conveyors 20A, 21A, 20C and 21C (when the table 30 is in a front end position within a movable range), the transportation belts operate simultaneously and driven by a motor 22 provided on the table 30, thereby transporting the board P.

According to such a configuration, the board P is conveyed from the left-hand side of the apparatus into the main body of the inspecting apparatus 1 along the conveyors of the board transporting section 2, subjected to inspection processing in an inspection work region provided in substantially the middle of the base 11, and then transported from the right-hand side of the apparatus to the next step (direction of the outline arrow in the drawing).

As shown in Fig. 2, the table transporting section 3 has the table 30 of substantially rectangular plan view, a pair of guiderails 31 fixed along the Y-axis direction on the base 11, a ball screw shaft 32 rotatably supported and provided along the Y-axis direction on the base 11, and a motor 33 connected to one end of the ball screw shaft 32. The table 30 can move along the guiderails 31 and has a nut section (not shown) screwed to the ball screw shaft 32. Therefore, the table transporting section 3 moves the table 30 in the Y-axis direction along the guiderails 31 by rotating and driving the ball screw shaft 32 using the motor 33.

As shown in Fig. 2, the photographing device transporting section 4 has a gate-type support 41 provided in a standing manner in a position slightly rear of the center of the base 11 in a longitudinal direction (the vertical direction in Fig. 2) in a base surface of the base 11. This support 41 is constituted by leg sections (not shown) rising from end sections in the traverse direction, and a beam section 42 bridging upper end sections of the leg sections with each other. The beam section 42 of the support 41 is provided with an photographing unit 43 having the illuminating device 5 and photographing device 6 for photographing the board P, and a drive unit 44 for moving the photographing unit 43 along the support 41 . The drive unit 44 has a motor 45 placed on the beam section 42 of the support 41, a ball screw shaft 46 coupled to an output shaft of the motor 45 and extending in the traverse section, and a pair of guiderails 47 placed parallel to the ball screw shaft 46 on the beam section 42. The photographing unit 43 is supported by a supporting frame 48 screwed and attached to the ball screw shaft 46. Therefore, the photographing device transporting section 4 drives the motor 45 to move the photographing device 6 and the supporting frame 48 integrally in the X-axis direction along the guiderails 47.

The illuminating device 5 is configured by an illuminating device outputting infrared light such as an infrared LED (Light Emitting Diode), and is driven by voltage supplied by the control device 9 (to be referred to as "supply voltage" hereinafter). As shown in Fig. 4, for example, the illuminating device 5 is disposed above the board P along with the photographing device 6 to form the photographing unit 43, and made movable by the photographing device transporting section 4. Here, an infrared light LED 5a configuring the illuminating device 5 is placed such that an optical axis has an angle of 10 $\pm$ 6 degrees on the board P with respect to an axis perpendicular to the main surface of the board P. As shown in Fig. 4, when a pair of infrared LED 5a are provided, each of the pair may be provided line-symmetrically with respect to the abovementioned perpendicular axis. Such an illuminating device 5 can output infrared light having a wavelength of 875 $\pm$ 30 nm. As shown in Fig. 4, the illuminating device 5 may be provided with not only the infrared LED 5a but also a visible light LED 5b for radiating visible light.

The photographing device 6, configured by a CCD (Charge Coupled Device) camera and the like, is sensitive to an infrared wavelength range. The photographing device 6 performs photographing based on an instruction from the control device 9. As shown in Fig. 4, for example, the photographing device 6 is disposed above the board P along with the illuminating device 5 to form the photographing unit 43, and made movable by the photographing device transporting section 4.

The display device 7 is configured by a CRT (Cathode Ray Tube), LCD (Liquid Crystal Display), FED (Field Emission Display) or other known display device, a signal tower, and the like. Such a display device 7 displays various information based on the instruction from the control device 9. In the present embodiment, the display device 7 is configured by a display 7a provided on a side surface of the cover 10 and a signal tower 7b projecting upward from a top surface of the cover 10, as shown in Fig. 1.

The input device 8 is configured by devices that detect an input of information from the outside, such as a keyboard, mouse, pointing device, button, and touch panel. The information detected by the input device 8 is input to the control device 9. In the present embodiment, the input device 8 is configured by a keyboard 8a and mouse 8b provided in the vicinity of the display 7a, as shown in Fig. 1.

The control device 9 is a device for controlling the entire operation of the inspecting apparatus 1 and has a drive controller 91, illumination controller 92, image processor 93, I/F section 94, main controller 95, and storage 96, as shown in Fig. 3.

The drive controller 91 is a functional section for generating and outputting drive signals for driving the motor (not shown) and motor 22 of the board transporting section 2, the motor 33 of the table transporting section 3, and the motor 45 of the photographing device transporting section 4, on the basis of instruction from the main controller 95. Accordingly, movement of the board P, table 30, or photographing unit 43 can be realized.

The illumination controller 92 is a functional section for setting the supply voltage corresponding to the light intensity of the infrared light radiated by the illuminating device 5, and outputting the supply voltage to the illuminating device 5, on the basis of instruction from the main controller 95. Accordingly, infrared light of a predetermined intensity is outputted from the illuminating device 5.

The image processor 93 is a functional section for outputting an photographing instruction to the photographing device 6 based on an instruction from the main controller 95, performing A/D conversion or other image process on a captured image photographed by the photographing device 6 based on the photographing instruction, and outputting the obtained photographic data. Accordingly, photographic data that shows the grayscale of the light intensities of the pixels (to be referred to as "primary photographic data" hereinafter) as shown in Fig. 5, for example, can be generated.

The I/F section 94 displays various information to the display device 7 based on the instruction from the main controller 95. The I/F section 94 further transmits the various information detected by the input device 8 to the main controller 95. The I/F section 94 also transmits/receives various information such as type data relating to a printer 101 for printing cream solder to the board, a mounting apparatus 102 for mounting an electronic component onto the board and the type of the cream solder applied to the board by the printer 101, board data relating to the shape of the board applied with the cream solder, and mask data relating to the shape of a mask used in printing, the board being the inspecting apparatus 1.

The main controller 95 issues instructions to the illumination controller 92, image processor 93, drive controller 91 and I/F section 94 on the basis of the instructions from the outside such as a user or host computer, thereby realizing an inspection operation for inspecting the condition of the cream solder printed on the board. The main controller 95 has a condition acquisition section 95a for acquiring from the outside or storage 96 various conditions required for inspecting the cream solder, an illumination setting section 95b for setting the light intensity of infrared light radiated by the illuminating device 5 in accordance with the type of the cream solder, an photographing section 95c for causing the photographing device 6 to image the board applied with the cream solder, a binarization section 95d for comparing the primary photographic data with a predetermined threshold and binarizing the primary photographic data, an extraction section 95e for extracting a borderline (contour line) between a bright section and a dark section (to be referred to as "third-order photographic data" hereinafter) from the binarized photographic data (to be referred to as "secondary photographic data" hereinafter), an area calculation section 95f for detecting the cross-sectional shape of the cream solder from the secondary image and calculating the cross-sectional area thereof, a volume calculation section 95g for calculating the volume of the cream solder based on the calculated cross-sectional area, and a determination section 95h for determining the quality of the cream solder based on the calculated cross-sectional area or volume of the cream solder.

The storage 96 is a functional section that stores various information for realizing the operation of the inspecting apparatus 1. The storage 96 stores at least photographic data including the primary photographic data generated from the captured image photographed by the photographing device 6 and generated by the image processor 93, secondary image (binarized image) data binarized by the binarization section 95d, and photographic data 96a such as third-order photographic data representing the borderline (counter line) extracted by the extraction section 95e, reference information 96b relating to the various conditions required for inspecting the cream solder, threshold for creating the secondary photographic data by means of the binarization section 95d, and threshold for determining the quality of the cream solder by means of the determination section 95h, a determination result 96c by means of the determination section 95c and type correlation data 96d relating to the correlation between the type of the cream solder and the intensity of the infrared light.

The control device 9 is configured by a computer provided with a computing device such as a CPU, a storage device such as a memory and HDD (Hard Disc Drive) , and an I/F device for transmitting/receiving various information via the Internet, a LAN (Local Area Network), WAN (Wide Area Network) or other communication line, and a program installed in the computer. Specifically, by allowing the hardware device and software to work in coordination, the hardware resources described above are controlled so that the abovementioned drive controller 91 , illumination controller 92, image processor 93, I/F section 94, main controller 95, and storage 96 are realized. Note that the abovementioned program may be recorded in a recording medium, such as a flexible disc, CD-ROM, DVD-ROM, or memory card.

(Principle of Operation )

The principle of operation of the inspecting apparatus 1 according to the present embodiment is described next.

The cream solder is composed of solder powder and flux and formed into a paste by sufficiently kneading the solder powder and flux so that the solder powder is evenly dispersed within the flux. When infrared light is radiated onto the board applied with such cream solder, some of the infrared light reflects on the surface of the cream solder and the solder powder in the vicinity of the surface, while some of the infrared light penetrates through the flux within the cream solder and travels through the cream solder to reach an electrode pad configured by a metallic layer, and is then reflected by this electrode pad. The reflected light penetrates through the flux F within the cream solder again, and the infrared light emitted to the outside the cream solder is detected by the photographing device 6.

When penetrating through the cream solder as described above, the infrared light is scattered by the solder powder and attenuated by the flux. Therefore, because the thicker the cream solder, the longer distance the infrared light penetrates through the cream solder, the amount of components of the infrared light scattered and attenuated increases, resulting in a decrease of the light intensity of the reflected light.

For example, as shown in Fig. 5, suppose that infrared light I1 is radiated to a rim section of a cream solder H having a substantially semicircular cross section and applied on an electrode pad E of the board P, and that infrared light I2 is radiated onto the center of the cream solder H. At this moment, the infrared light I1 has less components to be scattered or attenuated, due to a short distance x1 between the surface of the cream solder H through which the infrared light I1 penetrates and the electrode pad E. Therefore, the light intensity of the reflected light is high. On the other hand, the infrared light I2 has a number of components that can be scattered or attenuated, due to a long distance x2 between the surface of the cream solder H through which the infrared light I2 penetrates and the electrode pad E. Therefore, the light intensity of the reflected light is low.

Fig. 6A, Fig. 7A and Fig. 8A are diagrams showing captured images that are obtained by radiating infrared light of a predetermined intensity onto a board applied with the cream solder with a screen having a thickness of 50 μm, 70μm and 100μ m respectively in order to perform screen printing, and then photographing this board by means of the photographing device 6. Fig. 6B, Fig. 7B and Fig. 8B are diagrams showing the number of pixels contained in each gradation when the light intensity of each pixel of the captured images shown in Figs. 6A to 8A is expressed by 256 gradations. In each of Fig. 6A, Fig. 7A and Fig. 8A, the brightness of each pixel represents the light intensity of the infrared light reflected on the surface of the board. The higher the light intensity, the whiter the pixels, and the lower the light intensity, the darker the pixels.

As shown in Fig. 6A, Fig. 7A and Fig. 8A, silicon constituting the board does not generate much reflected light, because the infrared light penetrates therethrough. Therefore, the board is displayed dark. The electrode pad formed on the board reflects the infrared light, and therefore the board is displayed brightly.

When the cream solder is thick (70μm, 100μm) as shown in Fig. 7A and Fig. 8A, the light intensity of the reflected light becomes weak, and hence the cream solder is displayed dark on the electrode pad. In addition, the number of pixels of the brightness corresponding to the cream solder represented by a range z is increased, as shown in Fig. 7B and Fig. 8B.

On the other hand, when the cream solder is thin (50μm) as shown in Fig. 6A, the light intensity of the reflected light becomes strong and the board is displayed brightly. Therefore, the board and the electrode pad are hardly distinguishable from each other. Moreover, the number of pixels within the range z is reduced, as shown in Fig. 6B.

Because the light intensity of the reflected light changes according to the thickness of the cream solder, as described above, the cross-sectional shape of the cream solder can be detected based on an intensity distribution of the reflected light, that is, the brightness of the image. Specifically, because it is considered that the infrared light penetrates the same distance through the cream solder at the pixel parts of the same brightness, the thickness of the cream solder is the same at these pixel parts. Moreover, the region having a brightness lower than a certain brightness can be applied with at least a certain thickness of the cream solder.

Therefore, when the cream solder applied on each board P has a cross section (in a direction perpendicular to the surface of the board) shown in, for example, Figs. 9A to 9C, and when infrared light of a predetermined intensity is radiated to the each board P to image the board P, the images shown in Figs. 10A to 10C are obtained. Note that the top surfaces of the boards P shown in Fig. 9 and Fig. 10 are entirely applied with metallic plating corresponding to the electrode pad, and the cream solder is applied to a predetermined range on the electrode pads.

More specifically, as shown in Fig. 9A, when a cream solder a is applied in the shape of a truncated cone, the distance in which the infrared light penetrates through the inside of the cream solder becomes long in a planar region of the center of the truncated-conical shape cream solder, while the distance through which the infrared light penetrates through the inside the cream solder decreases toward the periphery from the center. Photographing the board P applied with such cream solder a generates a captured image shown in Fig. 10A. Specifically, the section on the outer periphery of the cream solder a that corresponds to the electrode pad is the brightest section because the infrared light does not penetrate through the inside of the cream solder. A section (reference numeral e1) between a rim section of the cream solder a and the center of the cream solder a is displayed dark toward the center, because the distance in which the infrared light penetrates through the inside the cream solder increases toward the center. The center (reference numeral e2) of the cream solder a is the darkest area because the distance in which the infrared light penetrates through the inside the cream solder is the longest.

As shown in Fig. 9A, on the other hand, when a cream solder b is applied thinner than the cream solder a, the distance in which the infrared light penetrates through the inside the cream solder becomes short. Therefore, as shown in Fig. 10B, the cream solder b is displayed on the image as a dark section (reference numeral f1) brighter than the dark section e1 shown in Fig. 10A. Note in the dark section f1 that the distance in which the infrared penetrates through the cream solder is long at a center (reference numeral f2) that is thicker than a rim section of the cream solder, the center f2 is displayed darker than the dark section f1.

As shown in Fig. 9C, when an air bubble d exists in a cream solder c having a truncated-conical shape, the distance in which the infrared light penetrates through the section corresponding to the air bubble d within the cream solder becomes short. Photographing such a cream solder c generates a captured image shown in Fig. 10C. Specifically, the section on the outer periphery of the cream solder c that corresponds to the electrode pad is the brightest section. A section (reference numeral g1) between a rim section of the cream solder c and the center of the cream solder is displayed dark toward the center, because the distance in which the infrared light penetrates through the inside the cream solder increases toward the center. Especially the section adjacent to the center is the darkest section. A center (reference numeral g2) having the air bubble d is displayed as a doughnut-shaped dark section brighter than the reference numeral g1 adjacent to the center, because the distance in which the infrared light penetrates through the inside the cream solder is shortened by the air bubble.

The cross-sectional shape of the cream solder having a predetermined thickness can be detected by, for example, creating a characteristic diagram shown in Fig. 11. Fig. 11 is a diagram showing the relationship between the film thickness of the cream solder and the brightness of pixels, which is generated when infrared light beams of a plurality of light intensities (the light intensity of the infrared light outputted from the infrared LED 5a increases as the number representing the infrared light beams such as h1 and h2 increases) are radiated to a board applied with a cream solder whose thickness is already known (the characteristic diagram of Fig. 11 shows fresh brightness that includes the infrared light reflected on the surface of the board and components reflected from the surface of the cream solder and that is not processed but photographed by the photographing device 6). In this characteristic diagram, the thicker the film thickness of each curve h1 to h6, the lower the amount of components reflected from the surface of the board. When the film thickness exceeds a predetermined thickness, only the components reflected from the surface of the cream solder remain, and each component keeps a substantially fixed brightness. Moreover, the characteristic diagram shows that the light intensity of the reflected light reflected on a predetermined thickness X increases as the light intensity of the infrared LED 5a serving as a light source increases (not only the components reflected from the surface of the board but also the components reflected from the surface of the cream solder increase). Note in Fig. 11 that a dashed line h7 indicates that the light intensity of a region below this line is the light components reflected on the surface. In other words, the light intensity of a region above the dashed line h7 indicates the brightness that includes both the light reflected from the surface of the cream solder and the light reflected from the surface of the electrode pad.

For example, in the case in which infrared light of an intensity corresponding to the curve h6 is radiated, when detecting the cross section of the cream solder of the thickness X, it can be detected that the pixels corresponding to the cross section of the cream solder of the thickness X are the pixels having brightness Y, based on the inclination of the curve h6. Therefore, detecting the pixels having the brightness Y or pixels having brightness less brighter than the brightness Y can allows the detection of the cross section of the cream solder of the thickness X. At this moment, binarization of the photographic data can detect the shape of the cross section of the cream solder more accurately. In this case, the brightness of the pixels corresponding to the thickness to be detected is obtained based on the curves h1 to h6 corresponding to the intensity of the infrared light radiated by the illuminating device 5, to binarize the photographic data with the value of the obtained brightness as a threshold. As a result, the secondary photographic data representing the cross section of the cream solder having the predetermined thickness can be acquired.

Moreover, because the thickness of the cross section that can be detected in accordance with the light intensity of the infrared light changes, the board applied with the cream solder can be photographed while changing the light intensity of the infrared light, so that a plurality of sliced cross sections of different thicknesses (heights) can be detected. In this manner, acquiring a plurality of cross sections of the cream solder and disposing and displaying these cross sections in accordance with the respective heights can display an approximate three-dimensional cream solder. At this moment, the number of times to image the board can be increased while slightly changing the light intensity of the infrared light, so that the larger the number of cross sections of the cream solder to be acquired is, the more the three-dimensional shape of the cream solder can be approximated and displayed.

The intensity of the reflected light is proportional to the intensity of the infrared light to be radiated. For example, because the higher the intensity of the infrared light is, the higher the intensity of the reflected light becomes as shown in Fig. 12, the brightness of the pixels corresponding to the cream solder becomes brighter. Specifically, the brightness of a cream solder r on an electrode q becomes brighter as the intensity of the infrared light is made stronger from an image s to an image u. Therefore, even on the images of the same brightness, the cream solder of the section irradiated with infrared light of high intensity can be thick as long as the intensity of the infrared light to be radiated is high.

As described above, the thickness of the cross section of the cream solder that can be detected based on the primary photographic data changes in accordance with the threshold for binarizing the primary photographic data and the light intensity of the infrared light. Therefore, plurality of secondary photographic data items having different thicknesses of the cross section of the cream solder can be acquired by executing a method of photographing a number of times while changing the intensity of the infrared light with a fixed binarization threshold, a method of changing the threshold when binarizing the photographed primary photographic data in a state in which the light intensity of the infrared light to be radiated is fixed to a predetermined value, or a method of combining these steps. Accordingly, the three-dimensional shape of the cream solder can be detected based on these secondary photographic data items.

Incidentally, the light intensity of the light reflected from the surface of the board varies depending on the type of the cream solder, and particularly the proportions of the components within the cream solder. This fact is explained with reference to Fig. 13.

As shown in Fig. 13, when the infrared light is radiated from the infrared LED 5a of the illuminating device 5 to the board P in which a cream solder consisting of a mixture of solder powder H and the flux F is applied on the electrode E, this infrared light travels as shown by the arrows a to d. The infrared light shown by the arrow a reaches the surface of the electrode pad E linearly from the surface of the cream solder, is then reflected on the electrode pad E, linearly passes through the inside of the flux, and then reaches the photographing device 6. The infrared light shown by the arrow b is reflected diffusely by the solder powder H in a section near the surface layer of the cream solder. The infrared light shown by the arrow c passes through between the solder powder H in the section near the surface layer of the cream solder, but this infrared light reflects on the surface of the solder powder H located on a lower layer and eventually does not reach the photographing device 6. The infrared light shown by the arrow d reaches the surface of the electrode pad E while being repeatedly reflected on the surface of the solder powder H, and is then reflected on the electrode pad E. The infrared light shown by the arrow d has components that reach the photographing device 6 while being repeatedly reflected on the surface of the solder powder H and components that are reflected on the surface of the solder powder H but do not eventually reach the photographing device 6.

The components that are effective in detecting the cross-sectional shape of the cream solder, i.e., the light reflected from the surface of the board is a part of the arrows a and d (the components that reach the photographing device 6). When the density of the solder powder H within the cream solder is low, the proportion of the light reflected by the solder powder H decreases, and hence these components have high light intensity. However, when the density of the solder powder H is high, the proportion of the light reflected by the solder powder H increases, and hence the light intensity decreases. Similarly, when the density of the solder powder H is the same, the smaller the particle diameter of the solder powder H is, the more frequently the infrared light collides with the solder powder H and scatters while passing through the flux between the solder powder. Consequently, the transmittance of the infrared light in the cream solder decreases, and the light reflected on the board out of the infrared light reaching the photographing device 6 is reduced. In this manner, the intensity of the light reflected from the surface of the board changes in accordance with the proportions of the solder powder H and flux within the cream solder and the particle diameter of the solder powder H. Particularly, in the case in which the density of the solder powder H is high, the particle diameter of the solder powder H is small, or the light intensity of the light reflected from the surface of the board is low, the photographing device 6 cannot detect the reflected light unless the light intensity of the infrared light radiated from the infrared LED 5a is increased. Therefore, in the present embodiment the light intensity of the infrared light radiated by the illuminating device 5 is set in accordance with the type of the cream solder, and particularly the composition of the solder powder H and flux within the cream solder.

Not only the light reflected from the surface of the board, but also the light reflected from the surface of the cream solder also varies in accordance with the proportions of the components of the cream solder.

For example, in the case in which the density of the solder powder H within the cream solder is low or the particle diameter of the solder powder H is large in the same density of the solder powder H, the amount of light colliding with and reflected from the solder powder H increases on the surface layer, and the amount of components penetrating through the cream solder out of the infrared light radiated to the cream solder increases, whereby the amount of light reflected from the surface of the cream solder decreases. Therefore, in the section on the periphery of the cream solder that does not have the metal pad, it is difficult to observe the contrast between this section and the dark section of the polyimide board, making the shape of the outer rim of the cream solder unclear. On the other hand, strong contrast is obtained between the section inside the metal pad and the metal pad, and hence the shape of the outer rim of the cream solder becomes clear.

In the case in which the density of the solder powder within the cream solder is high, the amount of components of the infrared light that penetrate through the cream solder decreases, and consequently more light is reflected from the surface of the cream solder increases. Therefore, in the section on the periphery of the cream solder that does not have the metal pad, strong contrast is obtained between this section and the dark section of the polyimide board, making the shape of the outer rim of the cream solder clear. On the other hand, it is difficult to observe the contrast between the section inside the metal pad and the metal pad, and hence the shape of the outer rim of the cream solder becomes unclear.

Therefore, the surface of the solder and the shape of the outer rim of the solder can be detected more explicitly by setting the light intensity of the infrared light radiated by the illuminating device 5 in accordance with the compositions of the solder powder and flux within the cream solder.

(Operation of Inspecting Apparatus)

The inspection operation conducted by the inspecting apparatus 1 according to the present embodiment is described next with reference to Fig. 14.

First, the condition acquisition section 95a of the main controller 95 acquires various data required for inspecting the condition of the cream solder applied to the board (step S1) . The various data mean, for example, the board data relating to the shape of the board and a wiring pattern formed in the board, mask data relating to the shape of the mask used for printing the cream solder on the board, photographing position order data relating to the positions and orders for performing photographing on the board, inspection position data relating to the positions for performing the inspection on the board, thickness data relating to the thickness of the cream solder to be detected, height correlation data indicating the relationship of the height of the cross section of the solder that can be detected, to the light intensity of the infrared light radiated by the illuminating device 5 and to the brightness of the pixels to be detected, image process selecting data relating to an image process to be selected, type data relating to the type of the cream solder applied to the board, and the type correlation data 96d. These data items are acquired from the storage 96, printer 101, host computer on a mounting line, and the like.

Once inspection data is acquired, the illumination setting section 95b sets the intensity of the infrared light radiated by the illuminating device 5, on the basis of the type correlation data 96d (step S2 ) . The type correlation data 96d is configured by, for example, information in which the type of the cream solder is associated with the intensity of the infrared light radiated onto the cream solder, as shown in Fig. 15. In Fig. 15, the intensity of the infrared light radiated onto a solder A is set lower than other solders. This is because, in the composition of the solder A, either a low proportion of solder powder or a large particle diameter of solder powder is established, and the transmittance of the infrared light in the solder A is high and the light reflected from the board can be detected by the photographing device 6 even without increasing the intensity of the infrared light. On the other hand, the intensity of the infrared light radiated onto a solder B is set higher than other solders. This is because, in the composition of the solder B, either a high proportion of solder powder or a small particle diameter of solder powder is established, and the transmittance of the infrared light in the solder B is low and the light reflected from the board cannot be detected by the photographing device 6 unless the intensity of the infrared light is increased.

The illumination setting section 95b specifies the type of cream solder from the type data relating to the type of cream solder applied to the board, the type data being acquired from the printer 101, and acquires from the type correlation data 96d a value of the intensity of the infrared light to be radiated when inspecting the specified cream solder. As a result, the infrared light having the intensity corresponding to the type of the cream solder, or in other words, the cream solder composition, can be radiated. Note that the type correlation data 96d can be generated by actually radiating the infrared light and detecting the cross section of the cream solder.

As described above, a method of photographing a number of times while changing the light intensity of the infrared light with a fixed binarization threshold, a method of changing the threshold when binarizing one photographed primary photographic data with a fixed light intensity of the infrared light, or a method of combining these methods can be performed to acquire a plurality of secondary photographic data items. Hereinafter, an example of acquiring the plurality of secondary photographic data items by photographing a number of times while changing the light intensity of the infrared light with a fixed binarization threshold is described. Therefore, once an inspection condition is acquired, the illumination setting section 95b obtains the number of times to perform the photographing for each cream solder to be inspected, and the value of the light intensity of the infrared light radiated every time by the illuminating device 5, on the basis of the height correlation data, thickness data, and type correlation data 96d. These number data and intensity data are associated with each board to be detected, along with the inspection position data and the image process selecting data. The associated data are called "inspection data" for convenience.

Once the intensity of the infrared light radiated by the illuminating device 5 is set, the photographing section 95c causes the drive controller 91 to drive the board transporting section 2, conveys the board that is applied with the cream solder by the printer 101, and disposes the board in a predetermined position on the table 30 (step S3). When the board is conveyed into the predetermined position, the photographing section 95c causes the drive controller 91 to drive the table transporting section 3 and the photographing device transporting section 4 on the basis of the photographing position order data and inspection position data, and disposes the photographing unit 4 above the cream solder to be detected on the board.

When the photographing unit 4 is disposed above the cream solder to be detected on the board, the photographing section 95c causes the illuminating device 5 to radiate the infrared light while changing the intensity thereof, on the basis of the inspection data, and causes the photographing device 6 to image the board for each intensity of the infrared light radiated from the illuminating device 5 (step S4) . Here, the intensity of the infrared light is set based on the intensity data. The amount of intensities of the infrared light radiated by the illuminating device 5 and the number of times of the photographing performed by the photographing device 6 are set based on the number data. As a result, a plurality of images having different light intensities of infrared light radiated onto the board can be captured. Because the infrared light radiated by the illuminating device 5 is set based on the type correlation data 96d, as described above, the images obtained by the photographing device 6 include an image of the light reflected from the surface of the board.

The photographing performed by the photographing device 6 may be performed until all of the photographing positions within one board are photographed based on the photographing position order data. In this case, each photographing is performed based on the associated number data and intensity data. Moreover, the captured images are stored in the storage 96 along with the photographing positions and the light intensities of the infrared light. Note that the captured images are subjected to photographing processing by the photographing processor 93, whereby the primary photographic data showing the grayscale of the light intensities of the pixels is generated.

Once the primary photographic data is generated, the main controller 95 selects any one of first to third image processes on the basis of the selecting data (step S5), and performs the selected image process (steps S6 to S8) . Each of the image processes is described hereinafter.

(First Image Process)

In the first image process, the primary photographic data is binarized and the cross-sectional area of the cream solder is calculated. This process is described with reference to Fig. 16.

First, in order to binarize the primary photographic data by means of a predetermined threshold, the binarization section 95d acquires the primary photographic data generated by the photographing section 95c and the mask data relating to the mask used by the printer 101 when applying the cream solder to the photographed board (step S11) . This mask data includes information on the position and shape of an opening of the mask, i.e. , information on the position and shape of the cream solder applied onto the board. Note that the mask data may be wider than the opening of the mask by a predetermined value. Accordingly, leakage or bridge of the cream solder can be detected.

When the primary photographic data and the mask data are acquired, the binarization section 95d segments primary photographic data of a region corresponding to the cream solder (target shape K) whose cross section is detected, from the primary photographic data generated by the photographing section 95c (step S12). The position of the target shape K is specified based on the mask data, and the primary photographic data of the region including the target shape K, which is the primary photographic data in which the pixels are aligned in the form of a matrix of I rows and J columns, is acquired.

When the primary data including the target shape K is segmented, the binarization section 95d binarizes the primary photographic data with a predetermined brightness as a threshold (step S13). Here, the threshold is set in accordance with the thickness of the cream solder to be acquired, on the basis of, for example, the characteristic diagram shown in Fig. 11. Therefore, in the case of acquiring a plurality of secondary photographic data items from one primary photographic data that is photographed with a fixed light intensity of the infrared light, the secondary photographic data items on cross sections having various thicknesses can be acquired from the one primary photographic data by changing the threshold.

Binarization of the primary photographic data by means of the predetermined threshold generates the secondary photographic data shown in Fig. 17. Fig. 17 shows the secondary photographic data in which the pixels are aligned in the form of a matrix of I rows and J columns (to be referred to as "region I, J" hereinafter), wherein the target shape K is included in the region I, J. In the pixels, "1" means the brightness of the threshold or higher, and "0" the brightness lower than the threshold. Specifically, the boundary section between a pixel indicated by "1" and a pixel indicated by "0" is the section having a predetermined thickness of the cream solder, and the section with "0" has the predetermined thickness or more. Therefore, the section corresponding to the pixel "0" means the cross section of the cream solder having the predetermined thickness. By binarizing the primary photographic data using the threshold as described above, the cross-sectional rim section of the cream solder can be obtained in detail and the contour thereof can be observed clearly, whereby the cross-sectional shape of the cream solder can be determined explicitly.

Once the binarization is performed, a target region K corresponding to the cross-sectional part of the cream solder out of the region I, J becomes a dark section indicated by "0. The binarization section 95b may display the secondary photographic data of the region I, J on the display device 7. As a result, the user can easily recognize the cross-sectional shape of the cream solder. Therefore, the user can determine the quality of the cream solder visually.

The area calculation section 95c of the main controller 95 measures the number of pixels corresponding to the dark section of the secondary photographic data, thereby measuring the area S of the cross section of the cream solder having the predetermined thickness (step S14). Specifically, the area calculation section 95c measure the number of pixels of the dark section in the region I, J subjected to image conversion. As a result, the cross-sectional area S of the cream solder with the predetermined thickness can be measured. Subsequently to the binarization performed in step S7, the cross-sectional area of the cream solder may be measured after performing data conversion for converting the pixels indicated by "1" in the region I, J to the dark section ("0" in the data) and the pixels indicated by "0" in to bright sections ("1" in the data). In this case, when the photographic data is displayed on the display device 7, the cross section of the cream solder is shown brightly, while the rest is shown dark. Even in this manner, the cream solder can be determined visually. The measurement of the cross-sectional area S of the cream solder is executed by measuring the number of pixels "1" corresponding to the cross section of the cream solder.

(Second Image Process)

In the second image process, the third-order photographic data showing the borderline between a bright section and dark section is detected from the secondary photographic data. This process is described with reference to Fig. 18.

First, the first image process described above is performed by the binarization section 95d and the area calculation section 95f (step S21).

Once the first image process is performed, the extraction section 95e detects a bright pixel region within a dark region contained in the secondary photographic data (step S22) . For example, in the case of the regions (I, J) shown in Fig. 17, a region with the pixels "0" indicating the dark section exists inside the pixels "1" on the outermost shell representing the electrode pad or the like, and a region with the pixels "1" representing the air bubble or the like and indicating the bright section exists within the pixels "0." The extraction section 95e extracts this bright region B. The detection of the bright region B can be performed by checking the positional relationship between the bright section and the dark section in the region (I, J) by, for example, setting the bright section near the center of the region (I, J) to the bright region B.

Once the bright region B is detected, the extraction section 95e detects a coordinate P1 (i, m) where the region having the pixels indicating the dark section is changed to the bright region B, and a coordinate P1 (i, n) where the bright region B is changed to the region having the pixels indicating the dark section (step S23). For example, each column J is changed in each row I (for example, each column J is moved from the left to the right), and, in each of the rows, the coordinate P1 (i, m) of the pixel where the region having the pixels indicating the dark section is changed to the bright region B, and the coordinate P1 (i, n) of the pixel where the bright region B is changed to the region having the pixels indicating the dark section are detected. Because the bright region B represents the air bubble contained in the cream solder, each coordinate P1 indicates the border between the cream solder and each air bubble.

When the coordinates P1 are detected, the extraction section 95e connects the coordinates P1 to obtain third-order photographic data (contour line) L1 (step S24). The contour line L1 consisting of the continuous coordinate P1 represents an outer rim of the air bubble within the cream solder.

Once the contour line L1 is set, the extraction section 95e detects a dark pixel region within the bright region contained in the secondary photographic data (step S25). For example, in the case of the region (I, J) shown in Fig. 17, the pixels "0" indicating the cream solder and the dark section exist inside the pixels "1" on the outermost shell representing the electrode pad and the bright section. The extraction section 95e detects this dark region C. Therefore, the bright region B is contained in the dark region C. The detection of the dark region C can be performed by checking the positional relationship between the bright section and the dark section in the region (I, J) by, for example, setting the dark section near the center of the region (I, J) to the dark region C.

Once the dark region C is detected, the extraction section 95e detects a coordinate P2 (i, o) of the pixel where the region having the pixels indicating the bright section is changed to the dark region C, and a coordinate P1 (i, p) of the pixel where the dark region C is changed to the region having the pixels indicating the bright section (step S26). For example, each column J is changed in each row I (for example, each column J is moved from the left to the right), and, in each of the rows, the coordinate P2 ( i , o ) where the region having the pixels indicating the bright section is changed to the dark region C, and the coordinate P2 (i, p) where the dark region C is changed to the region having the pixels indicating the bright section are detected. Because the dark region C represents the cream solder on the electrode pad, each coordinate P2 indicates the border between the electrode pad and the cream solder in the cross section indicated by the secondary photographic data.

When the coordinates P2 are detected, the extraction section 95e connects the coordinates P2 to obtain third-order photographic data (contour line) L2 (step S27). The contour line L2 consisting of the continuous coordinate P2 represents an outer rim of the cream solder on the electrode pad.

The second image process described above allows explicit detection of the cream solder having the predetermined thickness or the outer rim of the air bubble within the cream solder.

Note that the area calculation section 95f may calculate the cross-sectional area of the cream solder based on the extracted third-order photographic data (counter line) L1, L2. In this case, the calculation can be performed by counting the number of pixels within each contour line L1, L2 and obtaining the difference between the number of pixels within the contour line L2 and the number of pixels of the contour line L1. As a result, the cross-sectional area of the cream solder can be calculated accurately.

(Third Image Process)

In the third image process, the secondary photographic data and third-order photographic data (contour line) are acquired from the first image process and second image process described above, to detect the volume of the cream solder from these data. This process is described with reference to Fig. 19.

First, the volume calculation section 95g sets a value D of the number data to 1, a volume V0 of the air bubble within the cream solder to 0, and a volume V1 of the cream solder to 0 (step S31).

When the D, V0 and V1 are set, the volume calculation section 95g causes the extraction section 95e to perform the second image process based on the inspection data corresponding to the value of the number data (step S32). Accordingly, the third-order photographic data (contour lines) L1, L2 are calculated based on the secondary photographic data obtained by performing the $D^{th}$ photographing.

When the second image process is performed, the volume calculation section 95g calculates the volume v1 of the air bubble contained in the cream solder having the predetermined thickness on the basis of the calculated contour line L1 (step S33). Specifically, first, the volume calculation section 95g obtains area S1 within the contour line L1. This area S1 can be calculated by counting the number of pixels within the contour line L1. Next, the volume calculation section 95g obtains height F between the secondary photographic data obtained based on the previous photographing, which is the $(D-1)^{th}$ photographing, and the secondary photographic data obtained based on the present photographing, which is the $D^{th}$ photographing. This height F represents the height in a direction perpendicular to the board, and can be obtained from, for example, the threshold that is used when the binarization section 95c performs the binarization or from the characteristic diagram shown in Fig. 11. Once the height F is obtained, the volume calculation section 95g obtains the volume v1 by multiplying the height F by the area S1. This volume v1 means the volume of the air bubble in this height F. Note that when D = 1, the height F means the height from the top of the surface of the board or the cream solder to the secondary photographic data obtained based on the $D^{th}$ photographing.

Once the volume v1 is calculated, the volume calculation section 95g calculates a volume v0 of the cream solder having the predetermined thickness, on the basis of the calculated contour line L2 (step S34). Specifically, first, the volume calculation section 95g obtains area S2 within the contour line L2. This area S2 is calculated by counting the number of pixels within the contour line L2. The volume calculation section 95g then obtains the difference S0 between S2 and S1. This S0 represents the cross-sectional area of the cream solder only. Next, the volume calculation section 95g obtains the height F between the secondary photographic data obtained based on the previous photographing, which is the $(D-1)^{th}$ photographing, and the secondary photographic data obtained based on the present photographing, which is the $D^{th}$ photographing. This height F represents the height in a direction perpendicular to the board, and can be obtained from, for example, the threshold that is used when the binarization section 95c performs the binarization or from the characteristic diagram shown in Fig. 11. Once the height F is obtained, the volume calculation section 95g obtains the volume v0 by multiplying the height F by the area S0. This volume v0 means the volume of the cream solder having a thickness of the distance F. Note that when D = 1, the distance F means the distance between the top of the surface of the board or the cream solder and the secondary photographic data obtained based on the $D^{th}$ photographing.

When the v1 and v0 are calculated, the volume calculation section 95g obtains the value resulted from adding the v1 to the V1 as the V1, and the value resulted from adding the v0 to the V0 as the V0 (step S35) . As a result, the volumes of the cream solder and of the air bubbles in the thickness corresponding to the distance between the position of the cross section of the cream solder in the height direction that corresponds to the value of the number data D and the surface of the board or the top of the cream solder are calculated as the V1 or V0.

When the V1 and the V0 are updated, the volume calculation section 95g checks whether the number data D is the maximum value (step S36).

When the value of the number data D is not the maximum value (step S36: NO), the volume calculation section 95g increases the value of the number data D by 1 (step S37) , and returns to the process of step S32. When, on the other hand, the value of the number data D is the maximum value (step S36 : YES), the volume calculation section 95g ends the third image process.

The volume of the cream solder and the volume of the air bubble within the cream solder can be calculated by carrying out the third image process described above.

Note that the volume calculation section 95g may dispose all of the third-order photographic data (contour lines) L1, L2 extracted by the extraction section 95e at the respective heights and displays these third-order photographic data on the display device 7. Accordingly, an approximate three-dimensional cream solder and the condition of the inside of the cream solder can be displayed, whereby an operator can check the condition of the cream solder clearly. At this moment, the three-dimensional shape of the cream solder can be approximated and displayed by increasing the value of the number data or acquiring a large volume of secondary photographic data.

<Quality Determination Process>

When the cross-sectional area of the cream solder, the volume of the cream solder, and the volume of the air bubble are calculated by the first to third image processes, the determination section 95h performs a quality determination process for determining the quality of the cream solder to be inspected (step S9). This quality determination process is described with reference to Fig. 20.

First, the determination section 95h checks the executed image processes (step S41) . When the first or second image process is performed (step S41: first and second image processes), the determination section 95h determines the quality of the cream solder based on the calculated cross-sectional area of the cream solder. When, on the other hand, the third image process is performed (step S41: third image process), the determination section 95h determines the quality of the cream solder based on the calculated volumes of the cream solder and air bubble.

When the first and second image processes are performed, the determination section 95h compares the value of the calculated cross-sectional area S of the cream solder with a threshold $\alpha$ of a predetermined value and determines whether the cross-sectional area S is equal to or greater than the threshold $\alpha$, in order to determine whether the cream solder is applied appropriately (step S42). For example, when the cream solder is applied in a low amount or the air bubble exist inside the cream solder, or when the cross-sectional area S is smaller than the threshold $\alpha$, the determination section 95h determines that the area of the cream solder is not equal to or greater than the predetermined value. In this manner, excessively small amount of the cream solder or the presence of the air bubble can be detected. Here, when a plurality of cross sections are detected, the determination section 95h may perform the abovementioned determination on each cross section. In this case, the threshold $\alpha$ may be set for the height of each cross section, so that more accurate determination can be achieved. Note that the threshold $\alpha$ is set appropriately and freely based on the size and shape of the cream solder, as well as the height and the like of the cross section of the cream solder.

When the cross-sectional area S of the cream solder is equal to or greater than the threshold $\alpha$ (step S42: YES), the determination section 95h causes the drive controller 91 to drive the board transporting section 2 and the table transporting section 3 to convey the board from a predetermined position on the table 30 to the outside of the inspecting apparatus 1 (step S43). The board conveyed to the outside of the inspecting apparatus 1 is then conveyed into the mounting apparatus 102, and an electronic component is mounted on the board by the mounting apparatus 102.

When, on the other hand, the cross-sectional area S of the cream solder is not equal to or greater than the threshold $\alpha$ (step S42: NO), the determination section 95h determines that the quality of the cream solder is poor, and consequently causes the I/F section 94 to drive the display device 7 to perform a warning operation (step S44). In this warning operation, for example, the poor quality of the cream solder may be displayed on the display 7a, or the signal tower 7b may be caused to illuminate a lamp representing the alarm. As a result, the board applied with the poor-quality cream solder can be prevented from being conveyed out.

When the third image process is performed, the determination section 95h determines whether the calculated volume V1 of the air bubble within the cream solder is equal to or lower than a predetermined value $\beta 1$ (step S45). For example, when the bubble inside the applied cream solder is so large that the volume V1 exceeds the threshold $\beta 1$, the determination section 95h determines that the quality of the applied cream solder is poor. Note that the threshold $\beta 1$ is set appropriately and freely based on the size and shape of the cream solder.

When the volume V1 is equal to or lower than the threshold $\beta 1$ (step S45: YES), the determination section 95h determines whether the calculated volume V0 of the cream solder is equal to or greater than a threshold $\beta 0$ (step S46). For example, when the amount of the applied cream solder is so low that the volume V0 is below the threshold $\beta 0$, the determination section 95h determines that the quality of the applied cream solder is poor. Note that the threshold $\beta 1$ is set appropriately and freely based on the size and shape of the cream solder.

When the volume V0 is equal to or greater than the threshold $\beta 0$ (step S46: YES), the determination section 95h causes the drive controller 91 to drive the board transporting section 2 and the table transporting section 3 to convey the board from a predetermined position on the table 30 to the outside of the inspecting apparatus 1 (step S43). The board conveyed to the outside of the inspecting apparatus 1 is then conveyed into the mounting apparatus 102, and an electronic component is mounted on the board by the mounting apparatus 102.

When, on the other hand, the volume V1 is greater than the threshold β1 (step S45: NO) or the volume V0 is smaller than the threshold β0 (step S46: NO), the determination section 95h determines that the quality of the cream solder is poor, and causes the I/F section 94 to drive the display device 7 to perform the warning operation (step S44).

As described above, according to the present embodiment, because the illumination setting section 95b sets the intensity of the infrared light radiated from the illuminating device 5, in accordance with the type of the cream solder, which is in other words the cream solder composition, the photographing device 6 can acquire an image including an image of light reflected from the surface of the board, and detect the cross section of the cream solder from this image. Therefore, the condition of the inside of the cream solder can be detected, irrespective of a cream solder composition.

In addition, by radiating infrared light of a plurality of different intensities from the illuminating device 5 onto the board applied with the cream solder, and by using the photographing device 6 to image the board irradiated with the infrared light for each intensity, a plurality of images in which the intensities of the infrared light beams radiated onto the board are different can be acquired and the three-dimensional shape of the cream solder can be detected from these images. Therefore, the board applied with the poor-quality cream solder can be prevented from being conveyed out, by conveying the board or issuing an alarm in accordance with the condition of the inside of the cream solder. Particularly, because the three-dimensional shape of the cream solder including the inside of the cream solder can be detected, the cross-sectional shape of the cream solder can be recognized explicitly.

Note in the present embodiment that the plurality of secondary photographic data are acquired by performing the photographing a number of times while changing the light intensity of the infrared light with a fixed binarized threshold. However, the plurality of secondary photographic data may be acquired by changing the threshold for binarizing one primary photographic data with a fixed light intensity of the infrared light or combining the method of performing the photographing a number of times and the method of changing the threshold. In this case, the first image process creates the inspection data associated with each board and for inspecting the amount and value of the threshold used in binarization, or inspecting the amount and value of the threshold used in binarization, as well as the number of times to perform the photographing and the light intensity of the infrared light, along with the photographing position order data, inspection position data, and image process selecting data. Moreover, the number data D obtained in the third image process is taken as the order of changing the binarization threshold or the order of changing both the binarization threshold and the number of times to perform the photographing. In this manner, not only is it possible to acquire the plurality of secondary photographic data, but also the three-dimensional shape of the cream solder can be detected even when changing the binarization threshold or combining the method of performing the image a number of times with the method of changing the threshold.

Furthermore, in the operation of the inspecting apparatus, the illumination setting of step S2 shown in Fig. 14, which is performed based on the type correlation data 96d shown in Fig. 15, may be stopped. In this case, the threshold of the predetermined brightness that is used in step S13 in the first image process shown in Fig. 16 is added to a characteristic value shown in Fig. 11 to set the illumination based on the density of the solder powder or the particle diameter of the solder powder. Specifically, in terms of the solder composition, as with the solder A shown in Fig. 15, when the proportion of the solder powder of the solder B shown in Fig. 15 is smaller than that of the solder C or when the particle diameter of the solder B is larger than that of the solder C, the threshold of the predetermined brightness is set large to binarize the photographic data. In the case of the solder B, however, the proportion of the solder powder is large or the particle diameter of the solder is small, so the threshold of the predetermined brightness is set smaller than that of the solder A, to binarize the photographic data. By binarizing the photographic data using an appropriate threshold as above, the outer shape of the cream solder along the surface of the board or the cross-sectional shape of the cream solder along a surface separated from the board can be detected, irrespective of the type of the cream solder.

[Second Embodiment]

In the second embodiment, the intensity of the infrared light radiated onto the board applied with the cream solder is set in accordance with temporal change of at least either the illuminator or the cream solder. The second embodiment is described hereinafter with reference to Figs. 21 to 23.

(Constitution of Inspecting Apparatus)

The mechanical constitution of the inspecting apparatus is same as that of the first embodiment and shown in Figs. 1 and 2.

Fig. 21 shows the control device 9 for controlling the operation of the entire inspecting apparatus. As with the first embodiment, this control device 9 has the drive controller 91, illumination controller 92, image processor 93, I/F section 94, main controller 95, and storage 96.

The functions of the drive controller 91, illumination controller 92, image processor 93 and I/F section 94 are also the same as those described in the first embodiment.

The main controller 95 has the conditions storage 95a, setting section 95b', photographing section 95c, binarization section 95d, extraction section 95e, area calculation section 95f, volume calculation section 95g, and determination section 95h. The functions of these sections 95a, 95c, 95d, 95e, 95f, 95g and 95h other than the setting section 95b' are the same as those described in the first embodiment.

The setting section 95b' sets the intensity of the infrared light radiated by the illuminating device 5 in accordance with temporal change of the cream solder or illuminating device 5, the number of times the photographing device 6 images the board, and the threshold used when binarization section 95d described hereinafter performs binarization.

In addition, the storage 96 stores photographic data 96a, the reference information 96b, and a quality result 96c (same as those described in the first embodiment), and also stores at least correlation data 96e relating to the correlation between the temporal change of the cream solder and the light intensity of the photographic data, and LED correlation data 96f relating to the correlation between temporal change of the infrared LED 5a and the light intensity of the photographic data.

(Principle of Operation)

The principle of the operation for detecting the shape of the cream solder on the basis of an image obtained by photographing the board irradiated with infrared light is basically the same as that described in the first embodiment.

When radiating infrared light to the board, the intensity of the reflected light is proportional to the intensity of the radiated infrared light, as described above. Therefore, the intensity of the reflected light decreases due to temporal change of the infrared LED 5a (in other words, a change in which the intensity of the infrared light decreases as the accumulated operating time from first use of the infrared LED 5a increases).

Therefore, in the present embodiment the intensity of the infrared light radiated by the illuminating device 5 is set in accordance with temporal change of the infrared LED 5a. Note that the intensity of the infrared light radiated by the illuminating device 5 is set as follows. An electric power supply line (not shown) is connected to the illuminating device 5. This electric power supply line is connected to the infrared LED 5a via a power conditioner (not shown) provided in the middle. The setting section 95b' sets an increase correction value of the amount of supplied electric power corresponding to the temporal change of the infrared LED 5a (a change in which the efficiency of converting the electric energy into the infrared light with time), and the illumination controller 92 controls the power conditioner, whereby the amount of electric power supplied to the infrared LED 5a increases. As a result, the intensity of the infrared light radiated by the illuminating device 5 is kept at a predetermined intensity, irrespective of the temporal change of the infrared LED 5a.

Moreover, the light intensity of the light reflected from the surface of the board changes in accordance with temporal change of the cream solder. This fact is described with reference to the above-described Fig. 13.

As described above, when the infrared light is radiated from the infrared LED 5a of the illuminating device 5 to the board P in which the cream solder consisting of a mixture of the solder powder H and the flux F is applied on the electrode E, this infrared light travels as shown by the arrows a to d (see Fig. 13).

The components that are effective in detecting the cross-sectional shape of the cream solder, i.e., the light reflected from the surface of the board is a part of the arrows a and d (the components that reach the photographing device 6). As time passes since when a container containing the cream solder is opened to apply the cram solder to the board by means of a dispenser or printer, the container being prepared and manufactured in a factory, a solvent within the flux evaporates, the flux itself becomes modified, or the solder powder is deposited and consequently the density of the solder powder becomes high in some areas as the number of times to print the cream solder by means of squeegee movement increases after fresh cream solder is applied to a master screen. When such temporal change occurs, the infrared light penetrating through the flux is attenuated or reflected diffusely by the solder powder H. Therefore, the intensity of the infrared light reflected on the surface of the board and reaching the photographing device 6 becomes low. In this case, the photographing device 6 cannot detect the reflected unless the light intensity of the light intensity of the infrared light radiated from the infrared LED 5a is increased. Therefore, in the present embodiment the light intensity of the infrared light radiated by the illuminating device 5 is set in accordance with temporal change of the cream solder. Specifically, the increase correction value of the amount of supplied electric power is set to increase the intensity of the infrared light radiated from the infrared LED 5a, in accordance with temporal change of the cream solder.

(Operation of Inspecting Apparatus)

The inspection operation according to the present embodiment is basically the same as that of the first embodiment and carried out according to the abovementioned flowchart of step S14.

However, the various data acquired by the condition acquisition section 95a in step S1 includes the solder correlation data 96d and the LED correlation data 96e.

Once inspection data is acquired, the setting section 95b' sets the intensity of the infrared light radiated by the illuminating device 5, on the basis of the solder correlation data 96d and the LED correlation data 96e (step S2 in Fig. 14).

The solder correlation data 96d is configured from, for example, the characteristic diagram shown in Fig. 22. Fig. 22 is a diagram showing the relationship between the brightness of pixels on an image photographed by the photographing device 6 and cream solder use time, which is continuous printing time during which printing is performed by the printer 101 without exchanging the cream solder, when infrared light beams of a plurality of light intensities are radiated to a board applied with the cream solder whose thickness is already known. In Fig. 22, curves a1 to a6 show how the intensities of the infrared light beams increase toward the right-hand side (direction from the curve a1 to the curve a6).

For example, when the first intensity of infrared light obtained by the photographing device 6 is taken as a1, the light intensity of the reflected light from the board that is detected by the photographing device 6 is c1. When a time h1 elapses from this state, the light intensity of the reflected light from the board decreases with temporal change of the cream solder (c2). When photographing is performed in a state in which the light intensity of the reflected light is reduced, the binarization section 95d described hereinafter binarizes the value of the light intensity of a pixel by means of a predetermined threshold to generate the secondary photographic data of the cross section of the cream solder having a predetermined thickness. Therefore, the secondary photographic data of the cross section of the cream solder without the predetermined thickness is generated. The setting section 95b' sets the intensity of each infrared light outputted from the illuminating device 5, based on the characteristic diagram of Fig. 22. For example, in the case in which the photographing device 61 detects the light intensity of the reflected light reflected from the board as c1 after the time h1 elapses since the start of use of the cream solder, the intensity of each infrared light beam is set based on the following formula (1).

$$a2 + (a3 - a2)b/1 \ldots (1)$$

In the above formula (1), 1 represents the length of a straight line L, and b represents the length between the curve a2 and a point P on the straight line L. In Fig. 22, the point P represents the intersection of the time h1 and the light intensity c1, and the straight line L the distance between the curve a2 and the curve a3 that pass the point P. '

As described above, with the setting section 95b' the infrared light of an intensity corresponding to temporal change of the cream solder can be radiated by setting the intensity of each infrared light outputted by the illuminating device 5 based on the solder correlation data 96d. Note that the solder correlation data 96d can be generated by actually radiating infrared light and detecting the cross section of the cream solder. After the fresh cream solder is supplied onto the mask screen, the solder correlation data 96d may set the intensity of the infrared light outputted by the illuminating device 5, in accordance with the number of times to print the cream solder by means of squeegee movement. In this case, the solder correlation data 96d is configured by a characteristic diagram in which the horizontal axis shown in Fig. 22 is replaced with the number of time to print, in place of the characteristic diagram shown in Fig. 22.

In addition, as with the abovementioned solder correlation data 96d, the LED correlation data 96e is configured by a characteristic diagram that shows the relationship between a continued operation time of the infrared LED 5a and the brightness of the pixels of an image photographed by the photographing device 6, the relationship being obtained when infrared light of a predetermined intensity is radiated to the board applied with the cream solder. On the basis of this characteristic diagram, the setting section 95b' can radiate the infrared of an intensity corresponding to temporal change of the illuminating device 5 by setting the intensity of the infrared light outputted from the illuminating device 5. Note that the LED correlation data 96e can be generated by actually radiating the infrared light and detecting the cross section of the cream solder.

The LED correlation data 96e is configured by, for example, a characteristic diagram shown in Fig. 23. In Fig. 23, the vertical axis represents an emission intensity of the infrared light outputted by the infrared LED 5a, the horizontal axis an accumulated use time elapsed since when a new infrared LED 5a is used, and each of v1, v2, ... v6 a value of voltage applied to the infrared LED 5a. Specifically, the higher the voltage value, the larger the amount of electric power supplied to the infrared LED 5a.

When electric power having the voltage value v1 is supplied in the case of using the new infrared LED 5a, the emission intensity of the infrared LED 5a becomes r1, the accumulated use time h1, and the emission intensity r2. The amount of electric power supplied to the illuminating device 5 (the value of voltage applied to the infrared LED 5a) is set based on the following formula (2), in order to secure the same emission intensity r1 with the accumulated use time h1.

$$v2 + (v3 - v2)d/1 \ldots (2)$$

In the above formula (2), 1 represents the length of the straight line L which passes the point P and in which the distance between the curve v2 and the curve v3 is the shortest. d represents the length between the point P and the curve v2 on the straight line L. The point P represents the intersection of the time h1 and the emission intensity r1.

In this manner, the setting section 95b' can constantly radiate the infrared light of the predetermined intensity, irrespective of temporal change of the infrared LED 5a, by setting the intensity of the infrared light outputted by the illuminating device 5 on the basis of the LED correlation data 96e. In Fig. 23, if the value of voltage applied is large, the infrared LED 5a becomes slightly brighter than the infrared light of the predetermined intensity. In this case, feedback control may be performed to change the amount of electric power or, for example, the value of voltage supplied to the infrared LED 5a, so that, when a detection value of a disposed infrared sensor is taken as a target value when using the new infrared LED 5a and when the accumulated use time increases, the detection value of the infrared light of the infrared LED 5a that is obtained by the infrared sensor is as close to the target value as possible.

In the present embodiment, the setting section 95' sets the intensity of the infrared light outputted by the illuminating device 5, based on the abovementioned solder correlation data 96d and the LED correlation data 96e. Specifically, for example, the setting section 95b' calculates the intensity of the infrared light outputted from the illuminating device 5, based on the LED correlation data 96e, and sets the intensity of the infrared light outputted by the illuminating device 5, based on the calculated value and the solder correlation data 96d. As a result, the infrared light of an intensity corresponding to temporal change of the cream solder and infrared LED 5a can be radiated.

Subsequent to the illumination setting (step S2), the processes of steps S3 to S9 shown in Fig. 14 are executed. The image processes 1 to 3 performed in steps S6 to S8 are executed as shown in Fig. 16, Fig. 18 and Fig. 19, and the quality determination process of step S9 is executed as shown in Fig. 20. These processes are same as those described in the first embodiment.

According to the present embodiment, because the setting section 95b' sets the intensity of the infrared light radiated from the illuminating device 5 in accordance with temporal change of the cream solder or illuminating device 5, the photographing device 6 can detect the light reflected from the surface of the board in which the pixels corresponding to the predetermined thickness of the cream solder have a predetermined light intensity. Therefore, the condition of the cream solder can be detected based on the image obtained by the photographing device 6. As a result, the condition of the cream solder can be detected, irrespective of temporal change of the cream solder or infrared LED 5a.

Note in the present embodiment that although the setting section 95b' sets the intensity of the infrared light outputted from the illuminating device 5 on the basis of both the solder correlation data 96d and the LED correlation data 96e, the intensity of the infrared light may be set based on at least either the solder correlation data 96d or the LED correlation data 96e.

Moreover, in the present embodiment, although the intensity of the infrared light radiated by the illuminating device 5 is set in accordance with temporal change of the cream solder or infrared LED 5a, that is, although the amount electric power supplied to the infrared LED 5a is set, the illumination setting performed in step S2 shown in Fig. 14 may not be executed in the operation of the inspecting apparatus. In this case, the threshold of the predetermined brightness used in the step S13 during the first image process shown in Fig. 16 may be shifted to a low value. By binarizing the photographic data using an appropriate threshold as described above, the cross-sectional shape of the cream solder along the surface separated from the board ca be detected without changing the intensity of the infrared light radiated by the illuminating device 5, irrespective of temporal change of the cream solder or infrared LED 5a.

As described above, the inspecting apparatus of the present invention has: illuminator for irradiating a board applied with a cream solder with infrared light of a predetermined intensity; photographer for photographing the board irradiated with the infrared light; detector for detecting the shape of the cream solder based on the image obtained by the photographer; and setter for setting the intensity of the infrared light radiated by the illuminator, in accordance with a composition of the cream solder.

According to the present invention, the infrared light having the intensity set in accordance with the cream solder composition is radiated to the board applied with the solder, and the board irradiated with the infrared light is photographed, whereby the shape of the cream solder can be detected accurately, irrespective of the type of the cream solder.

The inspecting apparatus further has binarizer for binarizing the image obtained by the photographer by means of a brightness of a predetermined threshold, and the detector preferably detects the shape of the cream solder based on the binarized image obtained by the binarizer. Here, the detector may detect the cross-sectional shape of the cream solder along the surface separated from the board. The detector may also detect the three-dimensional shape of the cream solder based on any one set of: a plurality of binarized images obtained by using a predetermined threshold to binarize a plurality of images in which intensities of the infrared light radiated by the illuminator vary; a plurality of binarized images obtained by using a plurality of thresholds to binarize an image in which there is one intensity of the infrared light radiated by the illuminator; and a plurality of binarized images obtained by using a plurality of thresholds to binarize a plurality of images in which intensities of the infrared light radiated by the illuminator vary. Furthermore, the detector may further have: extractor for extracting a borderline between a dark section and a bright section of each of the binarized images; and calculator for calculating the volume of the cream solder on the basis of a plurality of the borderlines extracted by the extractor.

In addition, in the inspecting apparatus, the detector may detect the outer shape of the cream solder along the surface of the board. Here, the detector may detect the outer shape of the cream solder along the surface of the board on the basis of the binarized image obtained by the binarizer.

The inspecting apparatus may further have determinator for determining the condition of the cream solder based on a detection result obtained by the detector.

Moreover, another inspecting apparatus according to the present invention has: illuminator for irradiating a board applied with a cream solder with infrared light of a predetermined intensity; photographer for photographing the board irradiated with the infrared light; binarizer for binarizing the image obtained by the photographer by means of a brightness of a predetermined threshold; detector for detecting the shape of the cream solder based on the binarized image obtained by the binarizer; and setter for setting the threshold determined in the binarizer in accordance with a composition of the cream solder.

According to this invention, the shape of the cream solder can be detected accurately, irrespective of the type of the cream solder, by setting the threshold obtained in the binarizer in accordance with the cream composition.

In this inspecting apparatus, the detector may detect at least either the outer shape of the cream solder along the surface of the board or the cross-sectional shape of the cream solder along the surface separated from the board, on the basis of the binarized image obtained by the binarizer. The inspecting apparatus may further have determinator for determining the condition of the cream solder based on a detection result obtained by the detector.

In addition, another inspecting apparatus according to the present invention has: illuminator for irradiating a board applied with a cream solder with infrared light of a predetermined intensity; photographer for photographing the board irradiated with the infrared light; detector for detecting the shape of the cream solder based on the image obtained by the photographer; and first setter for setting the intensity of the infrared light radiated by the illuminator, in accordance with temporal change of at least either the illuminator or the cream solder.

Accordingly, the shape of the cream solder applied on the board can be detected accurately, irrespective of temporal change of the illuminator or the cream solder.

In this inspecting apparatus, the setter may set the intensity of the infrared light radiated by the illuminator, by using, as the temporal change of the illuminator, the accumulated use time elapsed since the start of use of the illuminator. In this way, the shape of the cream solder applied on the board can be detected accurately, irrespective of the time during which the illuminator is used.

In this inspecting apparatus, in order to set the intensity of the infrared light radiated by the illuminator, the setter may use, as the temporal change of the cream solder, at least either the number of times to print or the time between when the cream solder is newly supplied to the mask screen by the printer for printing the cream solder using the mask screen for applying the cream solder to the board, and when the printing is performed on the board to be inspected. As a result, the shape of the cream solder printed and applied onto the board by the printer can be detected accurately, irrespective of the time elapsed after supplying the cream solder to the mask screen or the number of time the printing is performed since the start of use of the cream solder.

In this inspecting apparatus, the illuminator may radiate the infrared light in response to electric power supply, and the setter may set the amount of electric power to be supplied. Accordingly, the shape of the cream solder applied onto the board can be detected accurately by simply setting the amount of electric power supplied to the illuminator, irrespective of temporal change of the illuminator or cream solder.

This inspecting apparatus may further have binarizer for binarizing an image showing an intensity distribution of the infrared light reflected from the board, by mans of a predetermined threshold, and the detector may detect the cross-sectional shape of the cream solder along the surface separated form the board, on the basis of the binarized image. Consequently, the cross-sectional shape of the cream solder along the surface separated from the board can be detected accurately, irrespective of temporal change of the illuminator or cream solder applied to the board.

This inspecting apparatus further has second setter for setting a plurality of intensities of the infrared light radiated by the illuminator in accordance with the cream solder, on the basis of the intensity of the infrared light that is set by the setter, and the detector may detect the three-dimensional shape of the cream solder based on a plurality of images photographed by the photographer and having different intensities of the infrared light. As a result, the three-dimensional shape of the cream solder applied onto the board can be detected accurately, irrespective of temporal change of the illuminator or cream solder.

In this inspecting apparatus, the detector may further have extractor for extracting a borderline between a dark section and a bright section of each image, and calculator for calculating the volume of the cream solder based on a plurality of borderlines extracted by the extractor. As a result, the volume of the cream solder applied onto the board can be detected, irrespective of temporal change of the illuminator or cream solder.

This inspecting apparatus may further have determinator for determining the condition of the cream solder based on a detection result obtained by the detector. Accordingly, the condition of the cream solder can be determined accurately, irrespective of temporal change of the illuminator or cream solder.

Moreover, another inspecting apparatus according to the present invention has: illuminator for irradiating a board applied with a cream solder with infrared light of a predetermined intensity; photographer for photographing the board irradiated with the infrared light; binarizer for binarizing the image obtained by the photographer by means of a brightness of a predetermined threshold; detector for detecting the shape of the cream solder based on the binarized image obtained by the binarizer; and setter for setting the threshold determined in the binarizer in accordance with temporal change of at least either the illuminator or the cream solder.

In this inspecting apparatus, the detector may detect the cross-sectional shape of the cream solder along the surface separated from the board, based on the binarized image obtained by the binarizer. Accordingly, the cross-sectional shape of the cream solder applied onto the board can be detected accurately, irrespective of temporal change of the illuminator or cream solder.

This inspecting apparatus may further have determinator for determining the condition of the cream solder on the basis of a detection result obtained by the detector. Accordingly, the condition of the cream solder applied onto the board can be determined accurately, irrespective of temporal change of the illuminator or cream solder.

Industrial Applicability

The present invention can be applied to a method and apparatus for inspecting a board applied with a cream solder.

## Claims

**1.** An inspecting apparatus, comprising:

an illuminator for irradiating a board applied with a cream solder with infrared light of a predetermined intensity;
a photographer for photographing the board irradiated with the infrared light;
a detector for detecting a shape of the cream solder based on the image obtained by the photographer; and
a setter for setting the intensity of the infrared light radiated by the illuminator in accordance with a composition of the cream solder.

**2.** The inspecting apparatus according to claim 1, further comprising a binarizer for binarizing the image obtained by the photographer by means of a brightness of a predetermined threshold, wherein the detector detects the shape of the cream solder based on the binarized image obtained by the binarizer.

**3.** The inspecting apparatus according to claim 2, wherein the detector detects a cross-sectional shape of the cream solder along a surface separated from the board, on the basis of the binarized image obtained by the binarizer.

**4.** The inspecting apparatus according to claim 2, wherein the detector detects a three-dimensional shape of the cream solder based on any one set of: a plurality of binarized images obtained by using a predetermined threshold to binarize a plurality of images in which intensities of the infrared light radiated by the illuminator vary; a plurality of binarized images obtained by using a plurality of thresholds to binarize an image in which there is one intensity of the infrared light radiated by the illuminator; and a plurality of binarized images obtained by using a plurality of thresholds to binarize a plurality of images in which intensities of the infrared light radiated by the illuminator vary.

**5.** The inspecting apparatus according to claim 4, wherein the detector comprises:

an extractor for extracting a borderline between a dark section and a bright section of each of the binarized images; and
a calculator for calculating a volume of the cream solder on the basis of a plurality of the borderlines extracted by the extractor.

**6.** The inspecting apparatus according to claim 1, wherein the detector detects an outer shape of the cream solder along a surface of the board.

**7.** The inspecting apparatus according to claim 2, wherein the detector detects an outer shape of the cream solder along a surface of the board on the basis of the binarized image obtained by the binarizer.

**8.** The inspecting apparatus according to any one of claims 1 to 7, further comprising a determinator for determining a condition of the cream solder on the basis of a detection result obtained by the detector.

**9.** An inspecting apparatus, comprising:

an illuminator for irradiating a board applied with a cream solder with infrared light of a predetermined intensity;
a photographer for photographing the board irradiated with the infrared light;
a binarizer for binarizing the image obtained by the photographer by means of a brightness of a predetermined threshold;

a detector for detecting the shape of the cream solder based on the binarized image obtained by the binarizer; and
a setter for setting the threshold determined in the binarizer in accordance with a composition of the cream solder.

**10.** The inspecting apparatus according to claim 9, wherein the detector detects at least either an outer shape of the cream solder along a surface of the board or a cross-sectional shape of the cream solder along a surface separated from the board, on the basis of the binarized image obtained by the binarizer.

**11.** The inspecting apparatus according to claim 9 or 10, further comprising a determinator for determining a condition of the cream solder on the basis of a detection result obtained by the detector.

**12.** An inspecting apparatus, comprising:

an illuminator for irradiating a board applied with a cream solder with infrared light of a predetermined intensity;
a photographer for photographing the board irradiated with the infrared light;
a detector for detecting a shape of the cream solder based on the image obtained by the photographer; and
a setter for setting the intensity of the infrared light radiated by the illuminator, in accordance with temporal change of at least either the illuminator or the cream solder.

**13.** The inspecting apparatus according to claim 12, wherein the setter sets the intensity of the infrared light radiated by the illuminator, by using, as the temporal change of the illuminator, the accumulated use time elapsed since the start of use of the illuminator.

**14.** The inspecting apparatus according to claim 12, wherein the setter sets the intensity of the infrared light radiated by the illuminator by using, as the temporal change of the cream solder, at least either time between when the cream solder is newly supplied to a mask screen in a printer for printing the cream solder using the mask screen for applying the cream solder to the board and when printing is performed on the board to be inspected or the number of times of printing.

**15.** The inspecting apparatus according to claim 12, wherein the illuminator radiates the infrared light by being supplied with electric power, and the setter sets the amount of electric power to be supplied.

**16.** The inspecting apparatus according to claim 12, further comprising:

a binarizer for binarizing an image showing an intensity distribution of the infrared light reflected from the board, by means of a predetermined threshold,
wherein the detector detects a cross-sectional shape of the cream solder along a surface separated form the board, on the basis of the binarized image.

**17.** The inspecting apparatus according to claim 12, further comprising:

a second setter for setting a plurality of intensities of the infrared light radiated by the illuminator in accordance with the cream solder, on the basis of the intensity of the infrared light that is set by the setter,
wherein the detector detects a three-dimensional shape of the cream solder based on a plurality of images photographed by the photographer and having different intensities of the infrared light.

**18.** The inspecting apparatus according to claim 17, wherein the detector comprises:

an extractor for extracting a borderline between a dark section and a bright section of each of the images; and
a calculator for calculating a volume of the cream solder on the basis of a plurality of the borderlines extracted by the extractor.

**19.** The inspecting apparatus according to any one of claims 12 to 18, further comprising a determinator for determining a condition of the cream solder on the basis of a detection result obtained by the detector.

**20.** An inspecting apparatus, comprising:

an illuminator for irradiating a board applied with a cream solder with infrared light of a predetermined intensity;
a photographer for photographing the board irradiated with the infrared light;
a binarizer for binarizing the image obtained by the photographer by means of a brightness of a predetermined threshold;
a detector for detecting the shape of the cream solder based on the binarized image obtained by the binarizer; and
a setter for setting the threshold determined in the binarizer in accordance with temporal change of at least either the illuminator or the cream solder.

**21.** The inspecting apparatus according to claim 20, wherein the detector detects a cross-sectional shape of the cream solder along a surface separated from the board, on the basis of the binarized image obtained by the binarizer.

**22.** The inspecting apparatus according to claim 20 or 21, further comprising a determinator for determining a condition of the cream solder on the basis of a detection result obtained by the detector.

FIG. 1

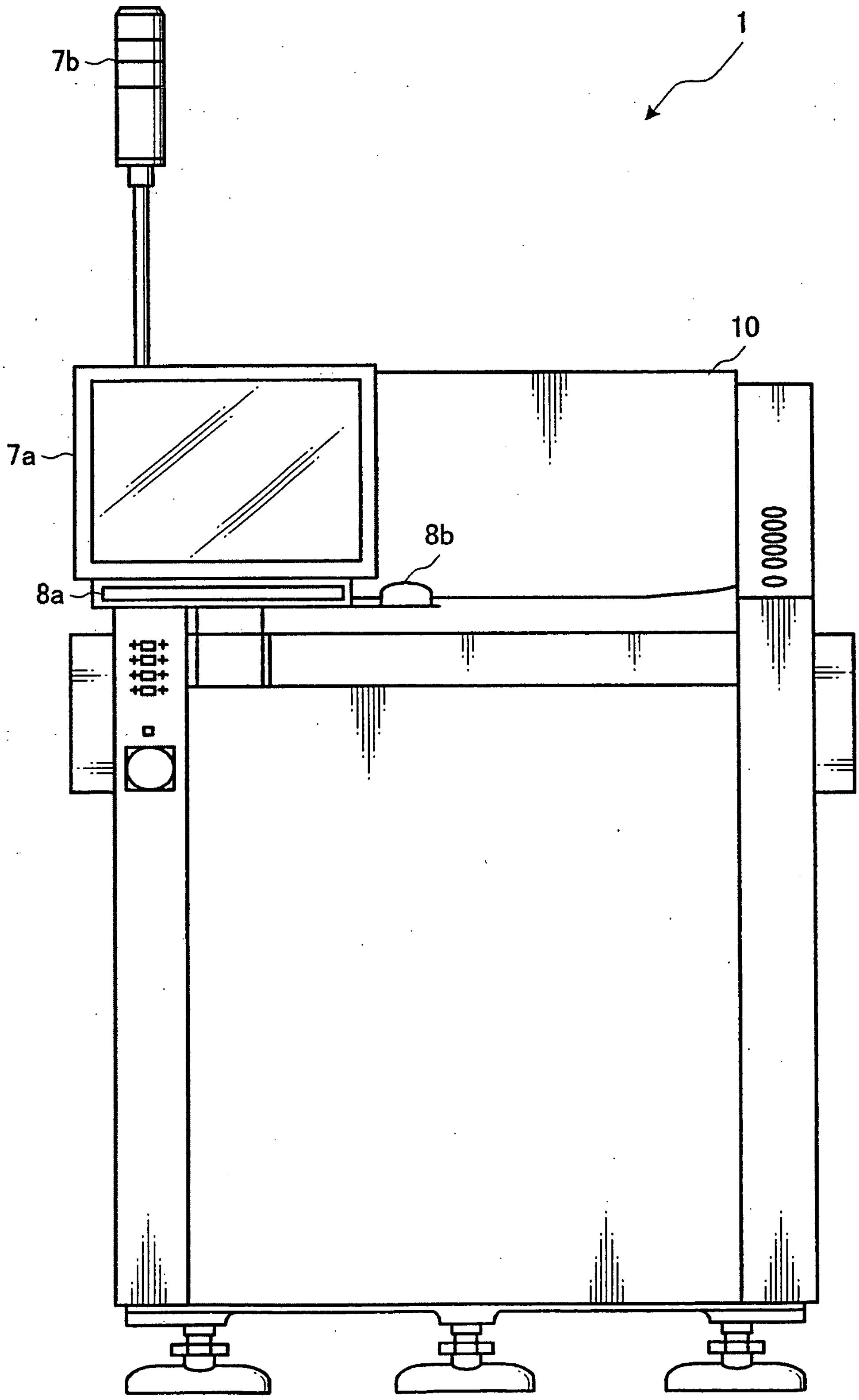

FIG. 2

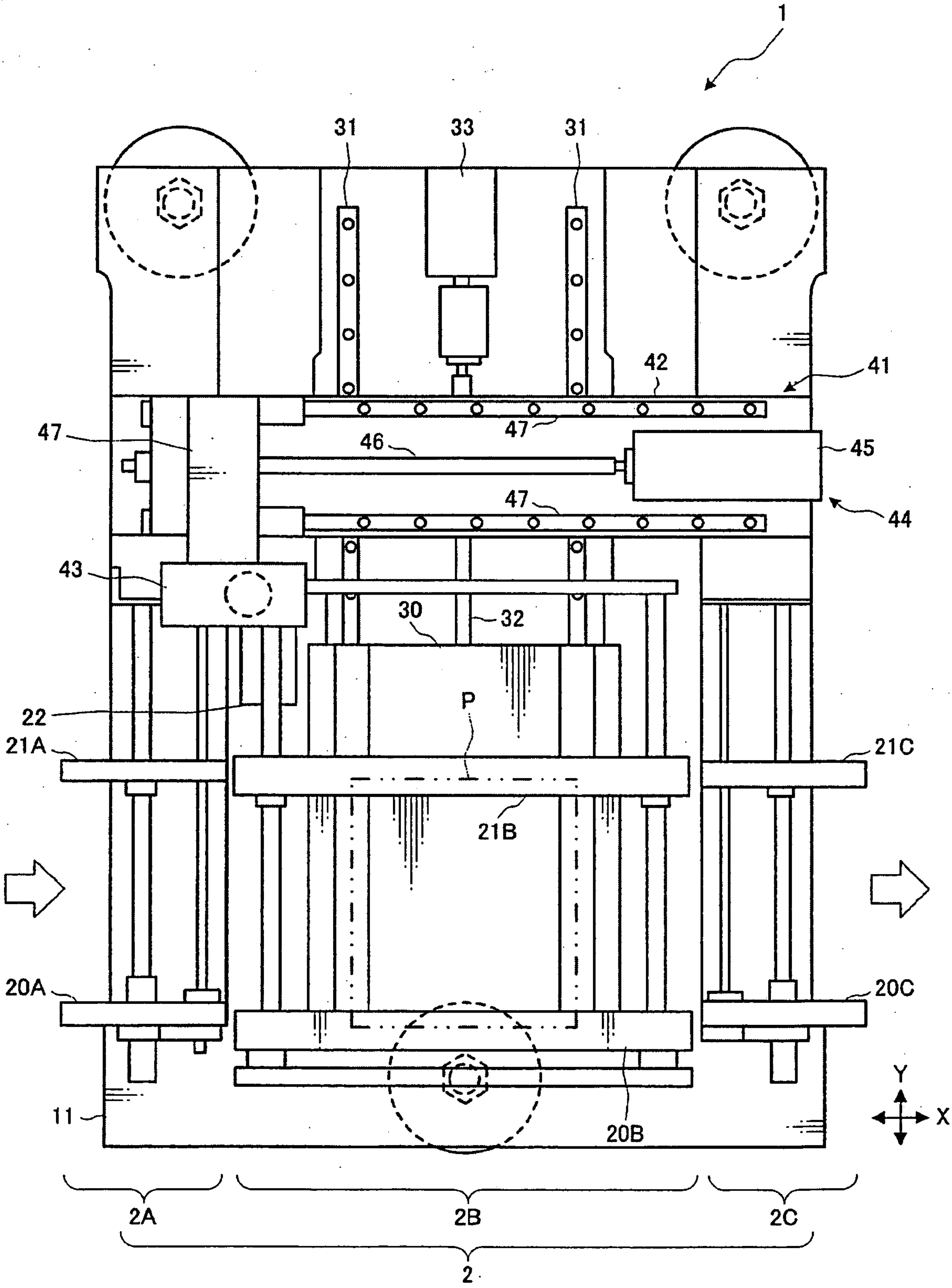

1
31
33
31
42
41
47
46
47
45
47
44
43
30
32
22
P
21A
21C
21B
20A
20C
11
20B
Y
X
2A
2B
2C
2

FIG. 3

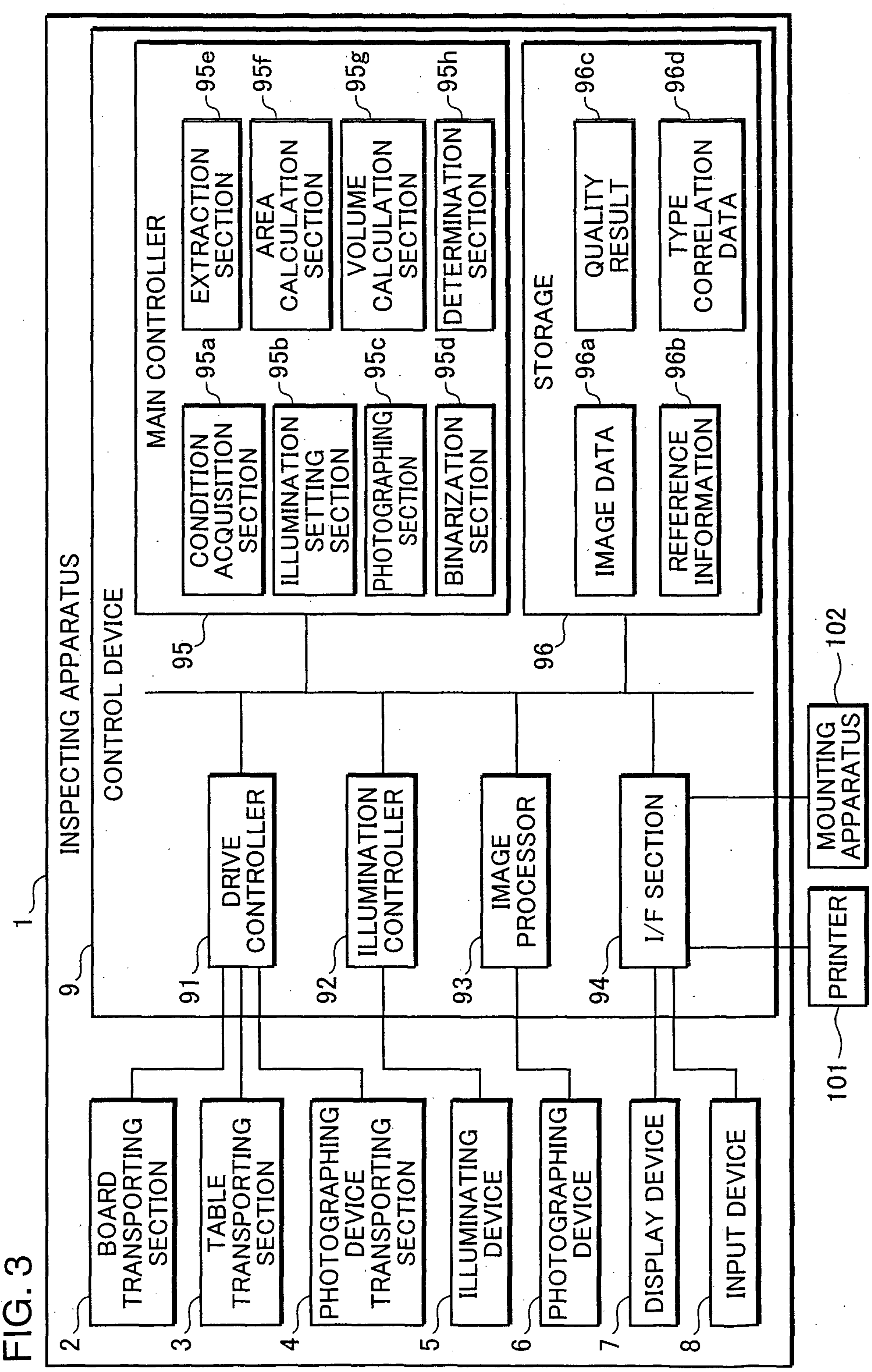
1
INSPECTING APPARATUS
9
CONTROL DEVICE
91
DRIVE CONTROLLER
92
ILLUMINATION CONTROLLER
93
IMAGE PROCESSOR
94
I/F SECTION
95
MAIN CONTROLLER
95a
CONDITION ACQUISITION SECTION
95b
ILLUMINATION SETTING SECTION
95c
PHOTOGRAPHING SECTION
95d
BINARIZATION SECTION
95e
EXTRACTION SECTION
95f
AREA CALCULATION SECTION
95g
VOLUME CALCULATION SECTION
95h
DETERMINATION SECTION
96
STORAGE
96a
IMAGE DATA
96b
REFERENCE INFORMATION
96c
QUALITY RESULT
96d
TYPE CORRELATION DATA
2
BOARD TRANSPORTING SECTION
3
TABLE TRANSPORTING SECTION
4
PHOTOGRAPHING DEVICE TRANSPORTING SECTION
5
ILLUMINATING DEVICE
6
PHOTOGRAPHING DEVICE
7
DISPLAY DEVICE
8
INPUT DEVICE
101
PRINTER
102
MOUNTING APPARATUS

FIG. 4

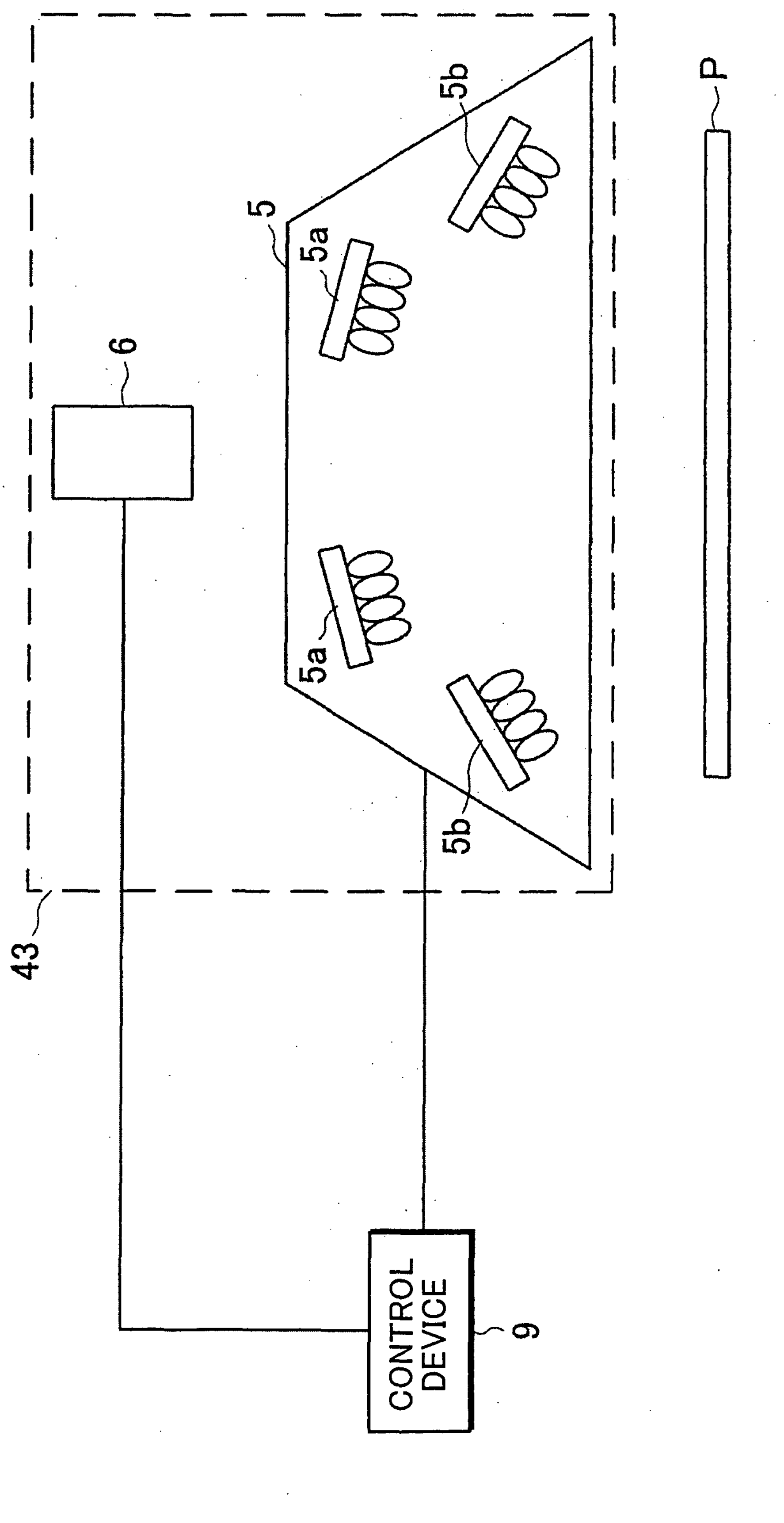

FIG. 5

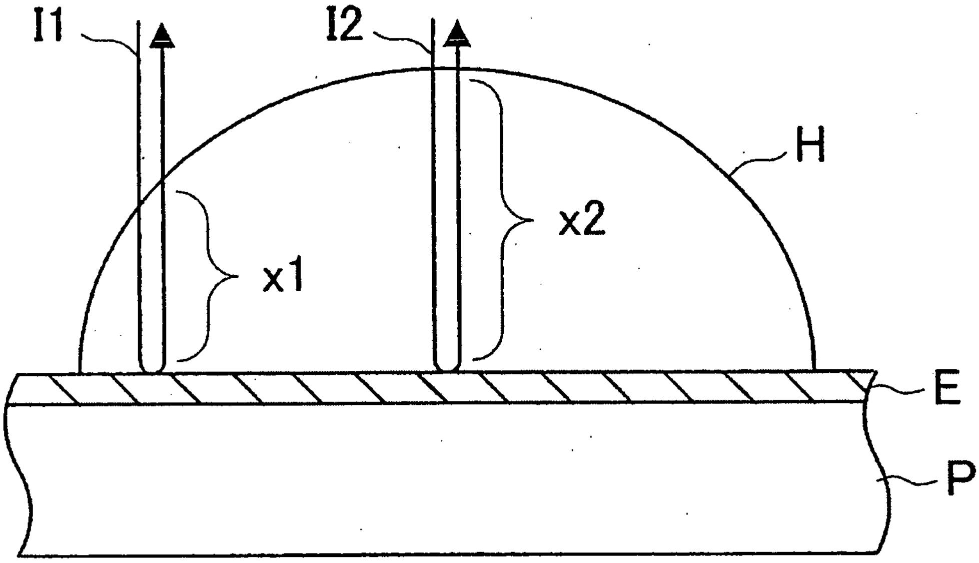

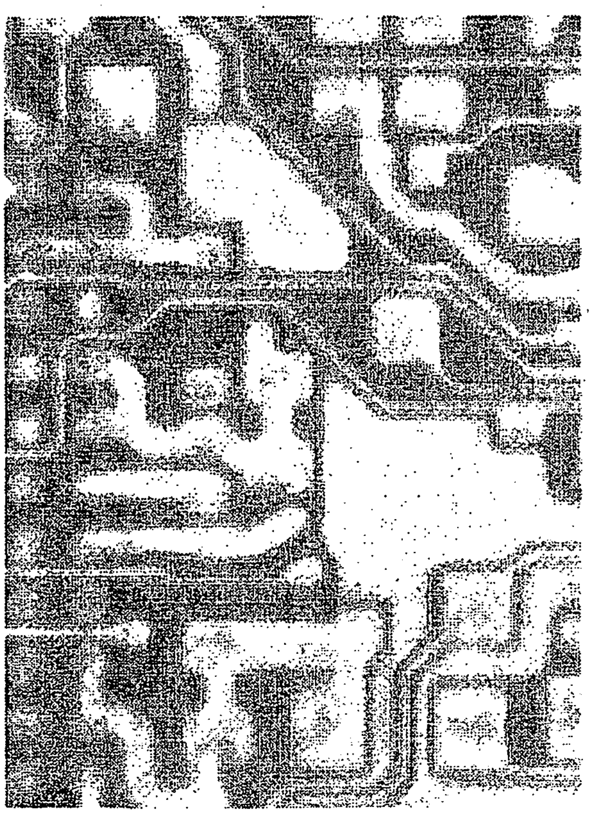

FIG. 6A

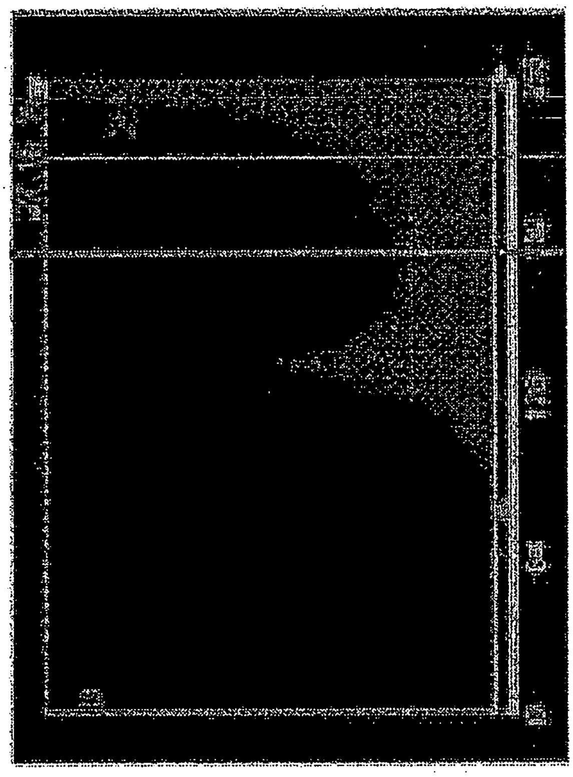

FIG. 6B

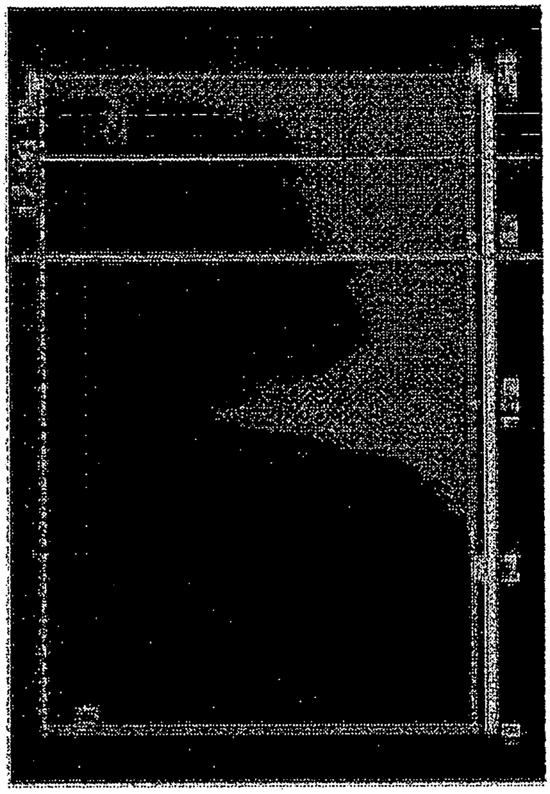

FIG. 7B

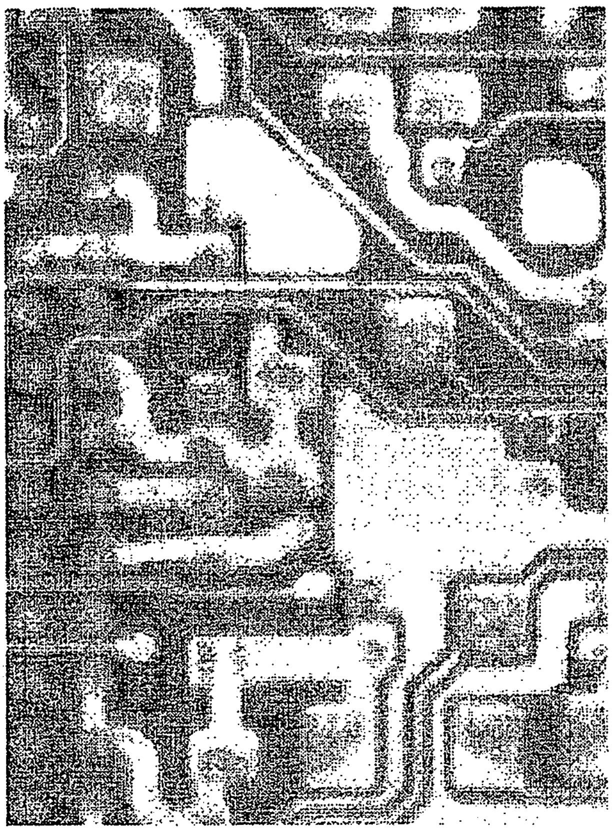

FIG. 7A

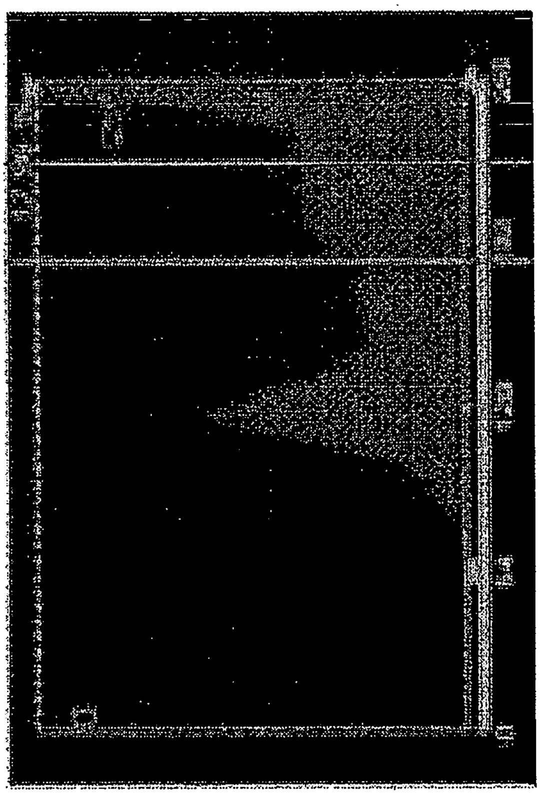

FIG. 8B

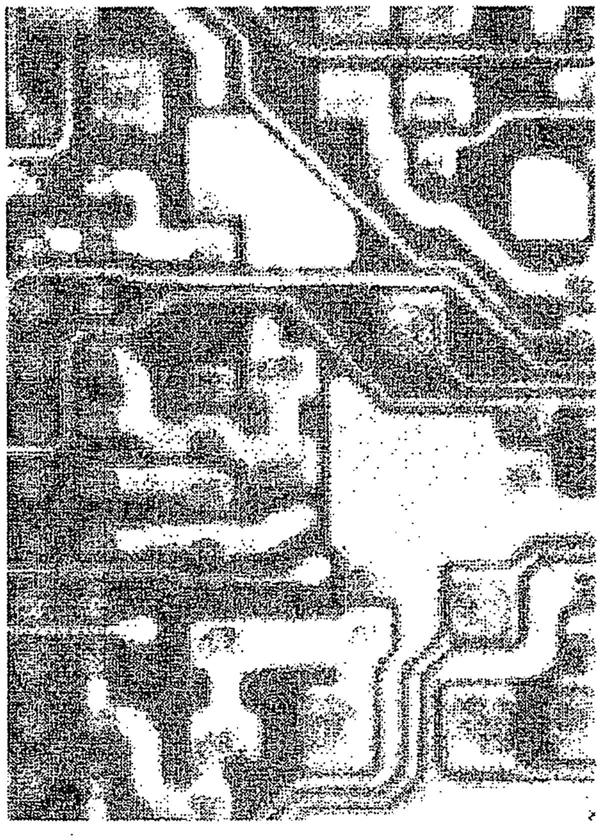

FIG. 8A

FIG. 9A

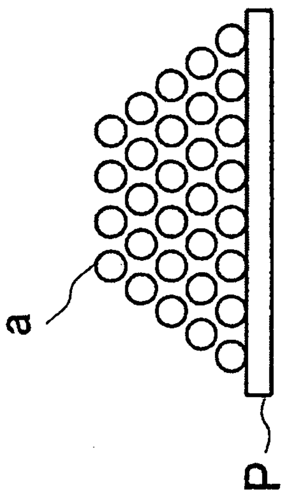


FIG. 9B

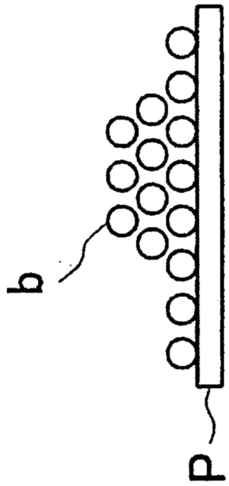


FIG. 9C

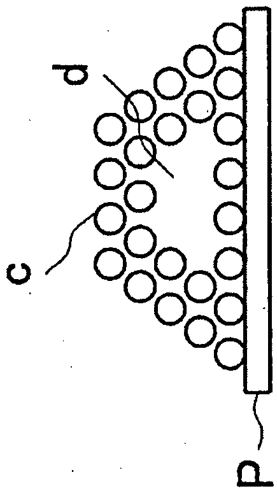

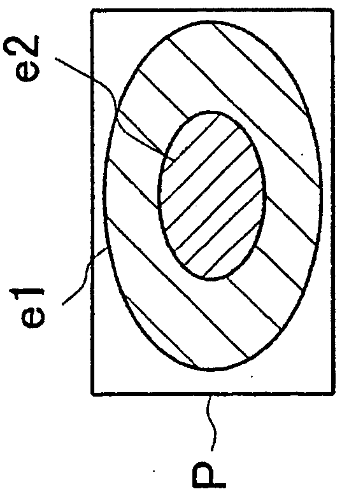


FIG. 10A

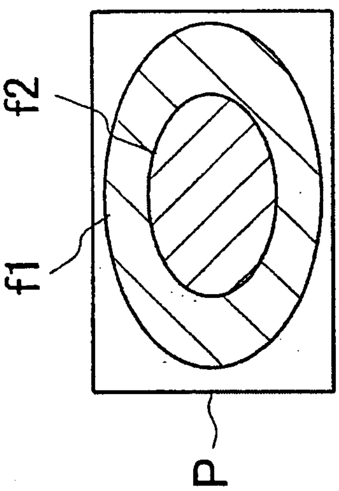


FIG. 10B

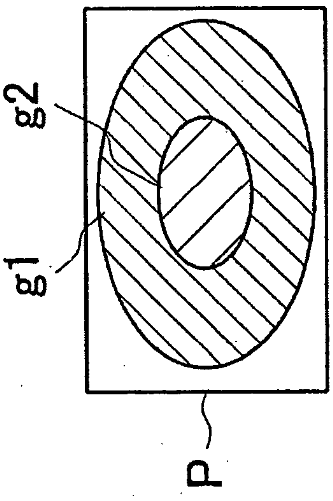


FIG. 10C

FIG. 11

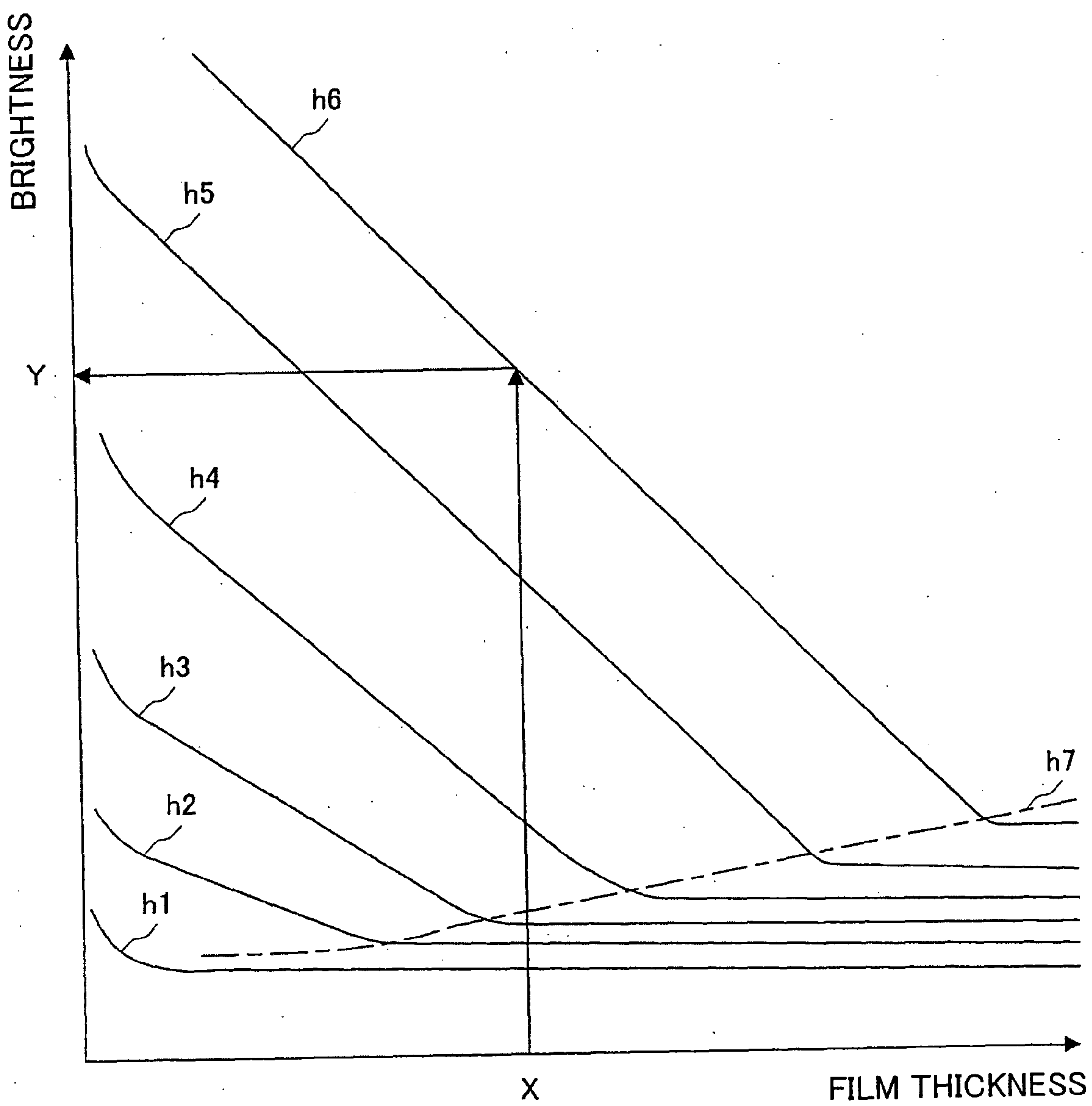

FIG. 12

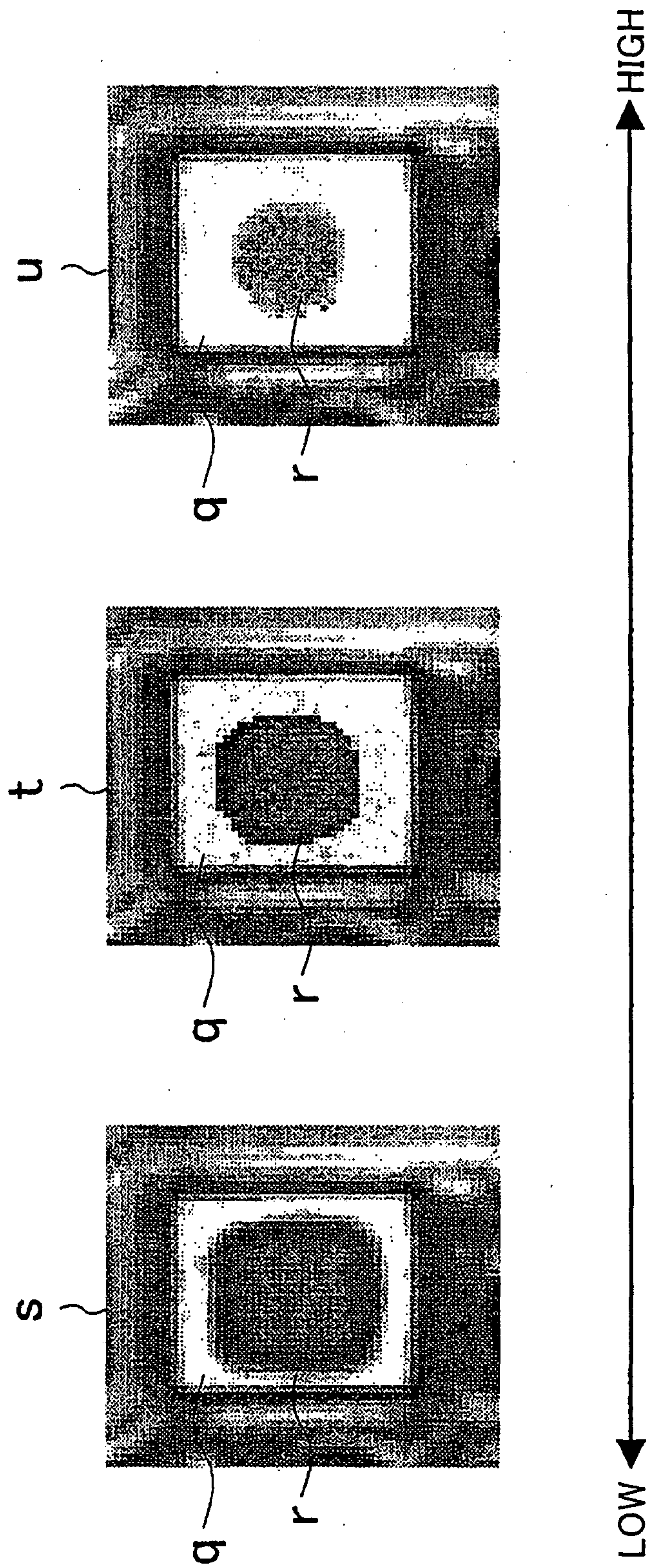

FIG. 13

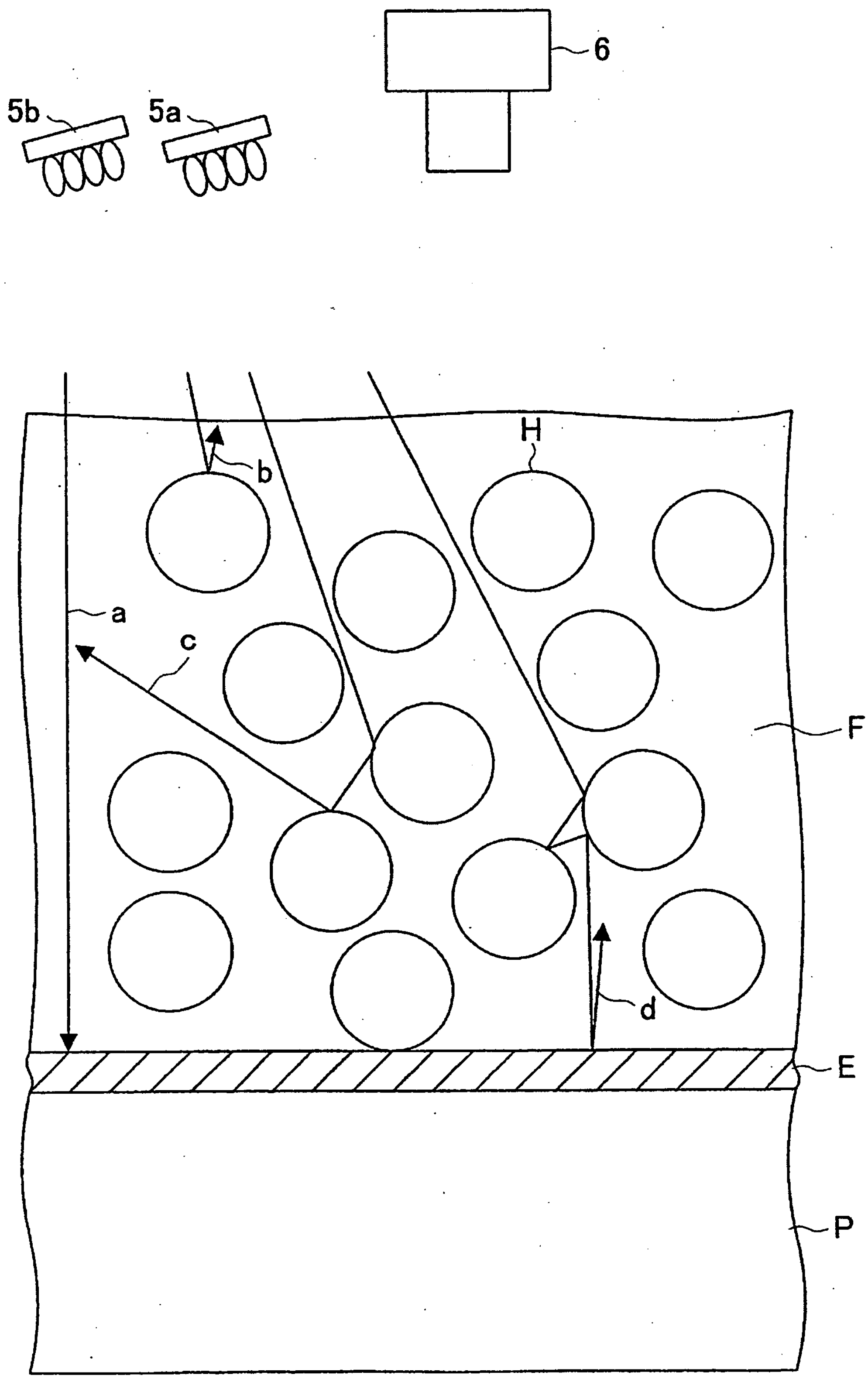

FIG. 14

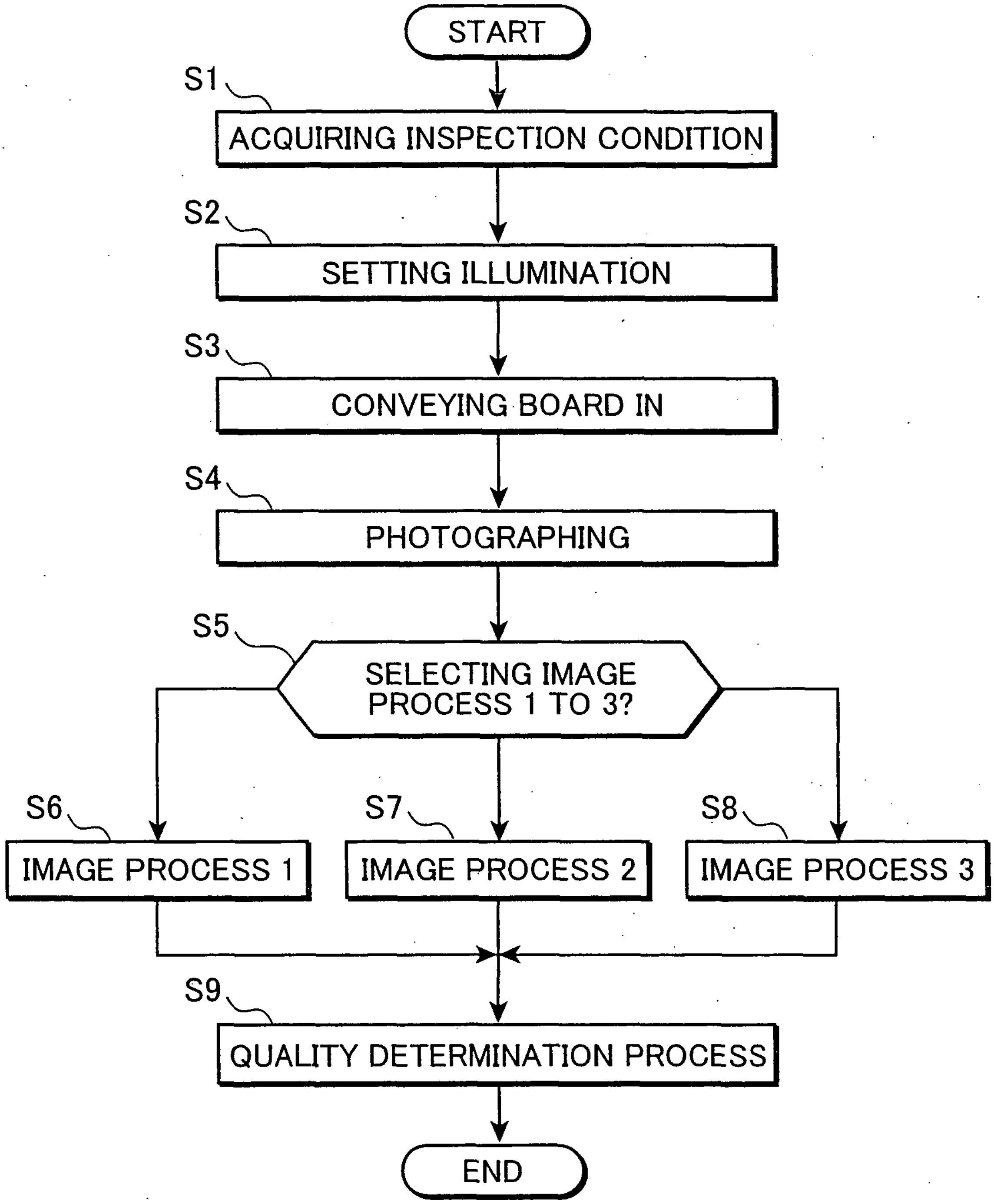
START
S1
ACQUIRING INSPECTION CONDITION
S2
SETTING ILLUMINATION
S3
CONVEYING BOARD IN
S4
PHOTOGRAPHING
S5
SELECTING IMAGE PROCESS 1 TO 3?
S6
IMAGE PROCESS 1
S7
IMAGE PROCESS 2
S8
IMAGE PROCESS 3
S9
QUALITY DETERMINATION PROCESS
END

FIG. 15

| SOLDER TYPE | LIGHT INTENSITY |
|---|---|
| SOLDER A | 80～120 |
| SOLDER B | 130～170 |
| SOLDER C | 100～150 |
| | |

FIG. 16

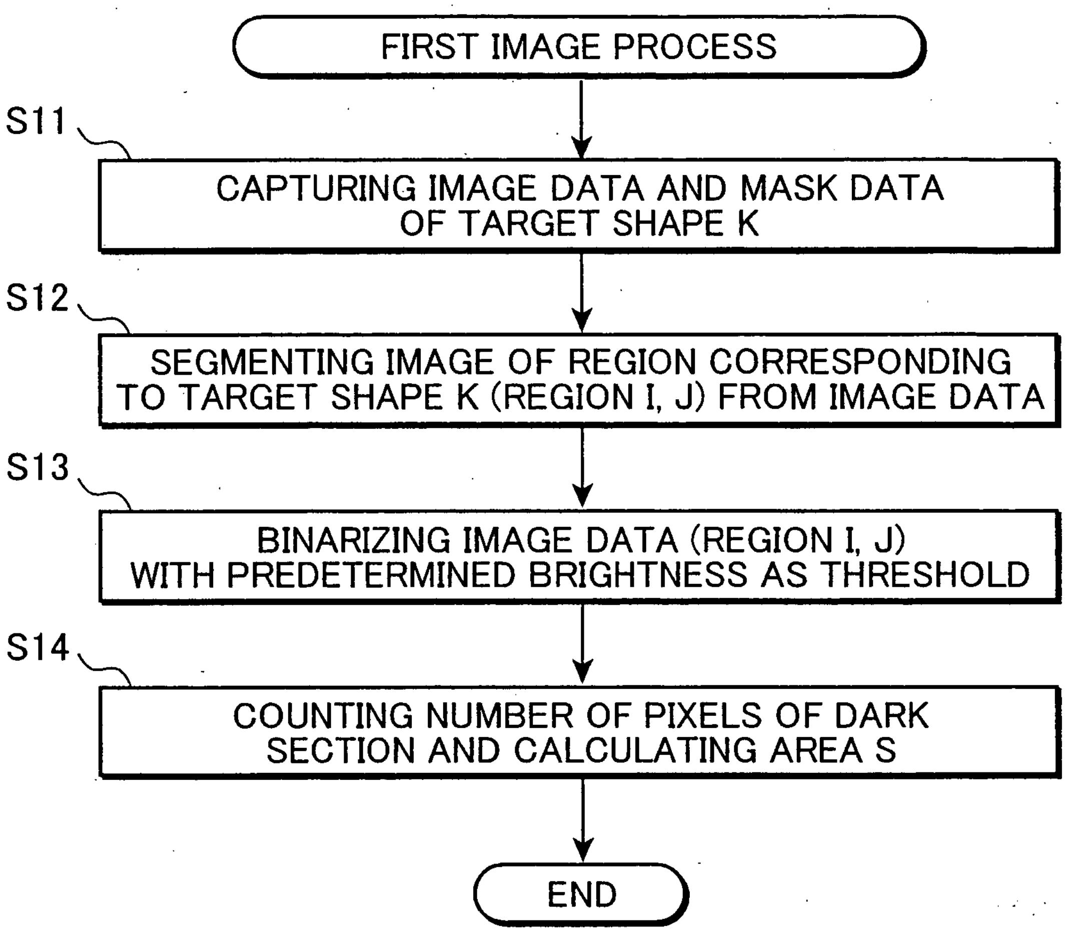
FIRST IMAGE PROCESS
S11
CAPTURING IMAGE DATA AND MASK DATA OF TARGET SHAPE K
S12
SEGMENTING IMAGE OF REGION CORRESPONDING TO TARGET SHAPE K (REGION I, J) FROM IMAGE DATA
S13
BINARIZING IMAGE DATA (REGION I, J) WITH PREDETERMINED BRIGHTNESS AS THRESHOLD
S14
COUNTING NUMBER OF PIXELS OF DARK SECTION AND CALCULATING AREA S
END

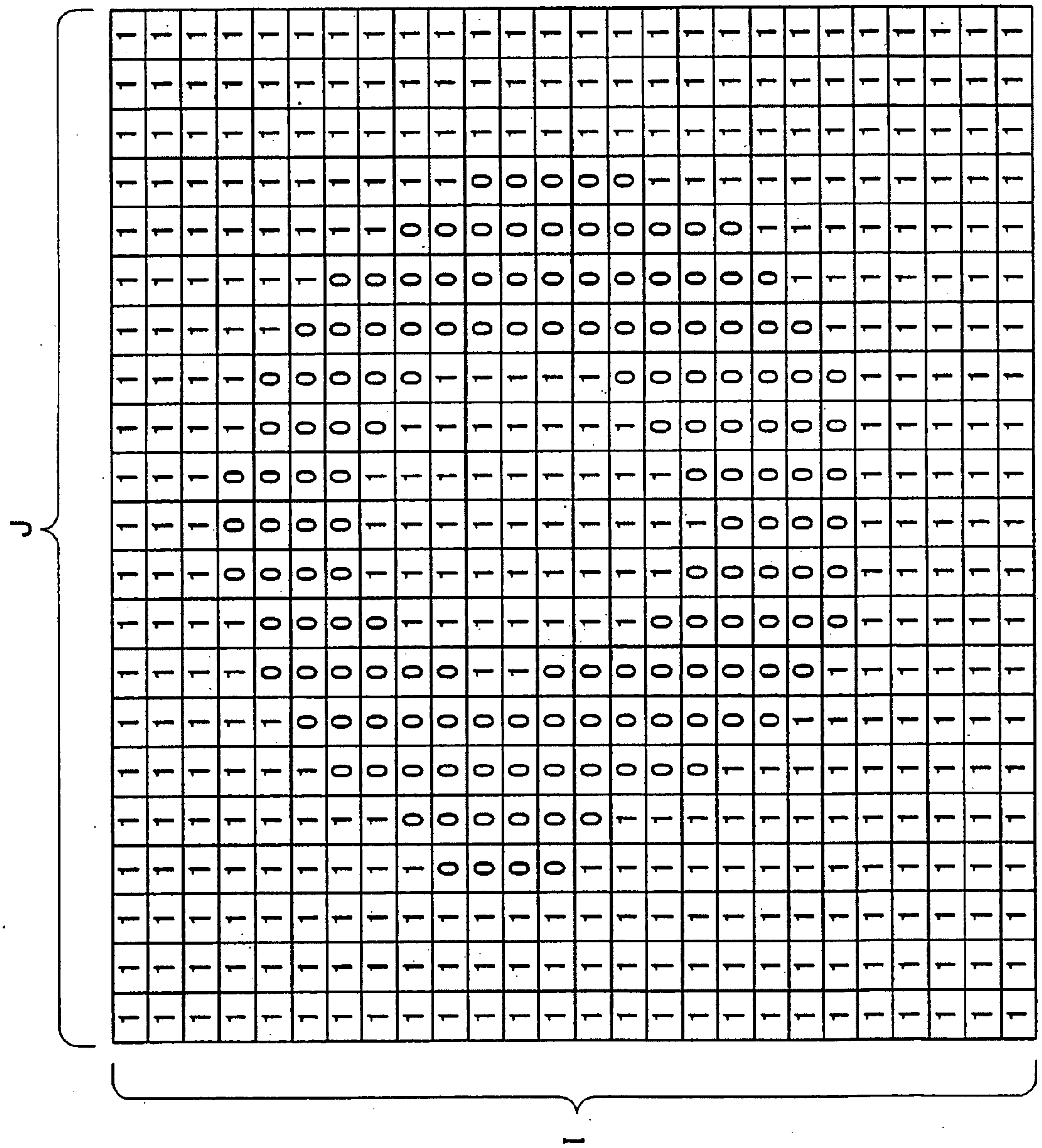


FIG. 17

FIG. 18

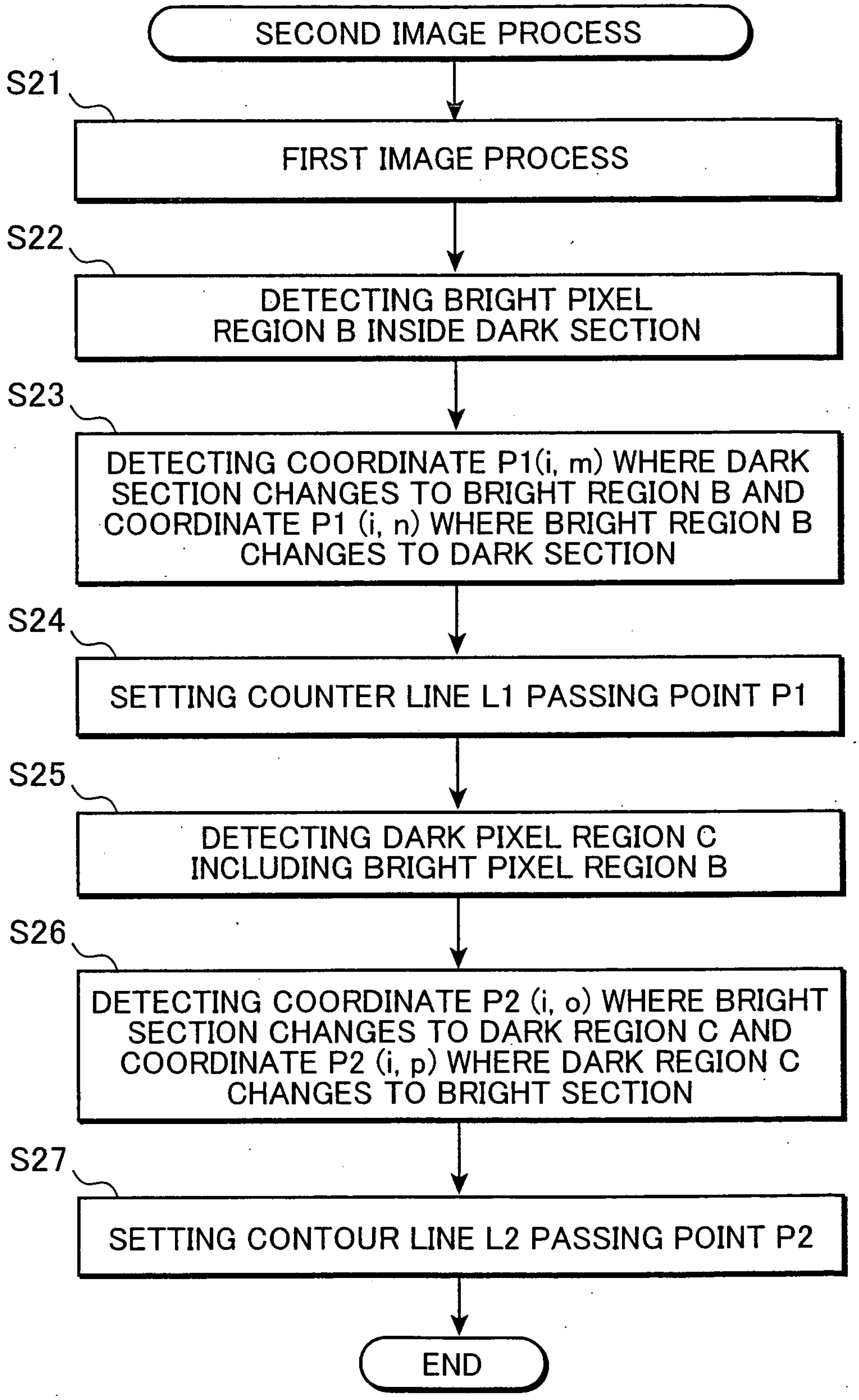
SECOND IMAGE PROCESS
S21
FIRST IMAGE PROCESS
S22
DETECTING BRIGHT PIXEL REGION B INSIDE DARK SECTION
S23
DETECTING COORDINATE P1(i, m) WHERE DARK SECTION CHANGES TO BRIGHT REGION B AND COORDINATE P1 (i, n) WHERE BRIGHT REGION B CHANGES TO DARK SECTION
S24
SETTING COUNTER LINE L1 PASSING POINT P1
S25
DETECTING DARK PIXEL REGION C INCLUDING BRIGHT PIXEL REGION B
S26
DETECTING COORDINATE P2 (i, o) WHERE BRIGHT SECTION CHANGES TO DARK REGION C AND COORDINATE P2 (i, p) WHERE DARK REGION C CHANGES TO BRIGHT SECTION
S27
SETTING CONTOUR LINE L2 PASSING POINT P2
END

FIG. 19

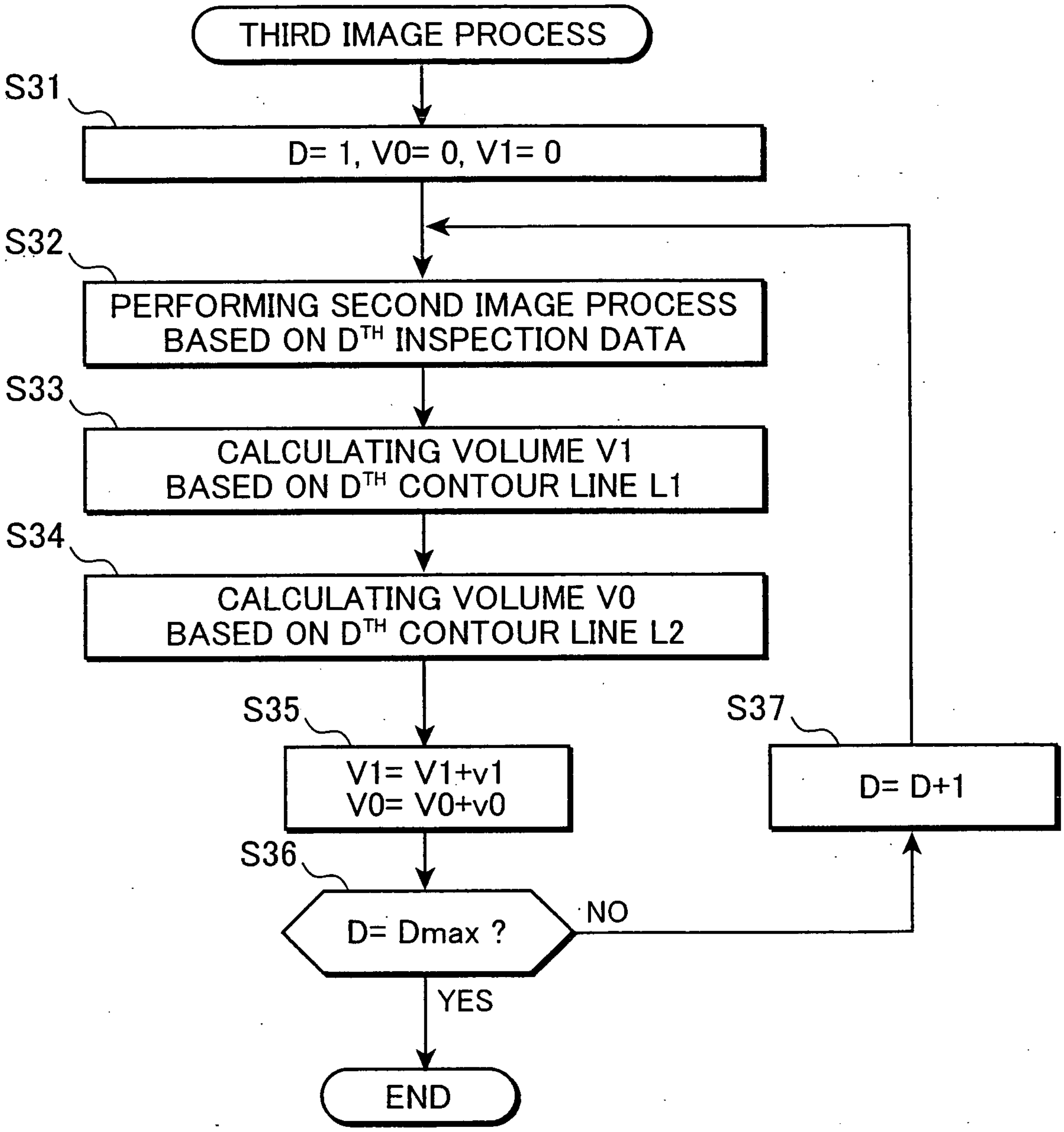
THIRD IMAGE PROCESS
S31
D= 1, V0= 0, V1= 0
S32
PERFORMING SECOND IMAGE PROCESS BASED ON D^TH INSPECTION DATA
S33
CALCULATING VOLUME V1 BASED ON D^TH CONTOUR LINE L1
S34
CALCULATING VOLUME V0 BASED ON D^TH CONTOUR LINE L2
S35
V1= V1+v1
V0= V0+v0
S36
D= Dmax ?
NO
YES
S37
D= D+1
END

FIG. 20

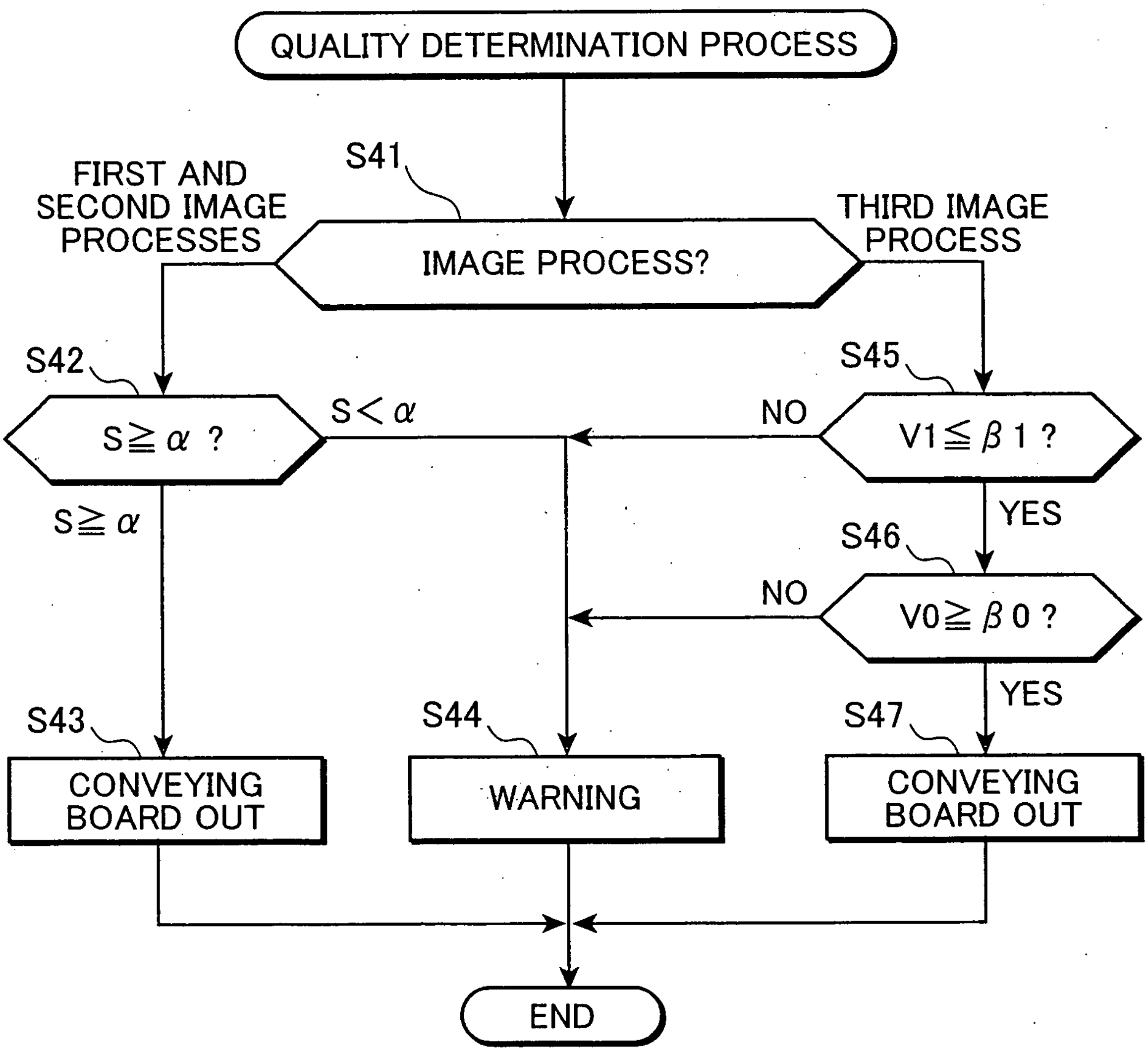
QUALITY DETERMINATION PROCESS
S41
IMAGE PROCESS?
FIRST AND SECOND IMAGE PROCESSES
THIRD IMAGE PROCESS
S42
S≧α ?
S<α
S≧α
S45
V1≦β1 ?
NO
YES
S46
V0≧β0 ?
NO
YES
S43
CONVEYING BOARD OUT
S44
WARNING
S47
CONVEYING BOARD OUT
END

FIG. 21

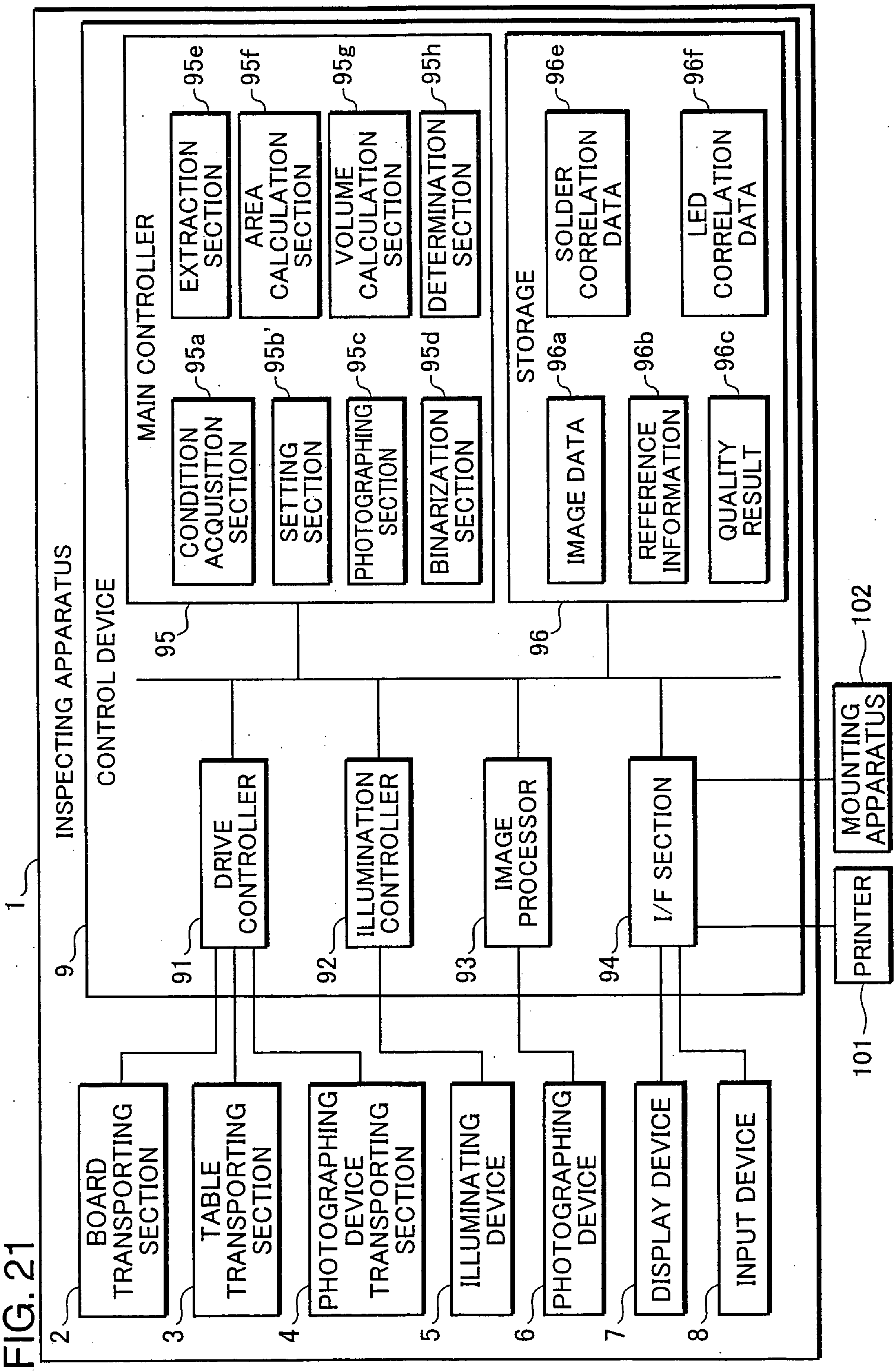
1
INSPECTING APPARATUS
9
CONTROL DEVICE
95
MAIN CONTROLLER
95a
CONDITION ACQUISITION SECTION
95b'
SETTING SECTION
95c
PHOTOGRAPHING SECTION
95d
BINARIZATION SECTION
95e
EXTRACTION SECTION
95f
AREA CALCULATION SECTION
95g
VOLUME CALCULATION SECTION
95h
DETERMINATION SECTION
96
STORAGE
96a
IMAGE DATA
96b
REFERENCE INFORMATION
96c
QUALITY RESULT
96e
SOLDER CORRELATION DATA
96f
LED CORRELATION DATA
91
DRIVE CONTROLLER
92
ILLUMINATION CONTROLLER
93
IMAGE PROCESSOR
94
I/F SECTION
101
PRINTER
102
MOUNTING APPARATUS
2
BOARD TRANSPORTING SECTION
3
TABLE TRANSPORTING SECTION
4
PHOTOGRAPHING DEVICE TRANSPORTING SECTION
5
ILLUMINATING DEVICE
6
PHOTOGRAPHING DEVICE
7
DISPLAY DEVICE
8
INPUT DEVICE

FIG. 22

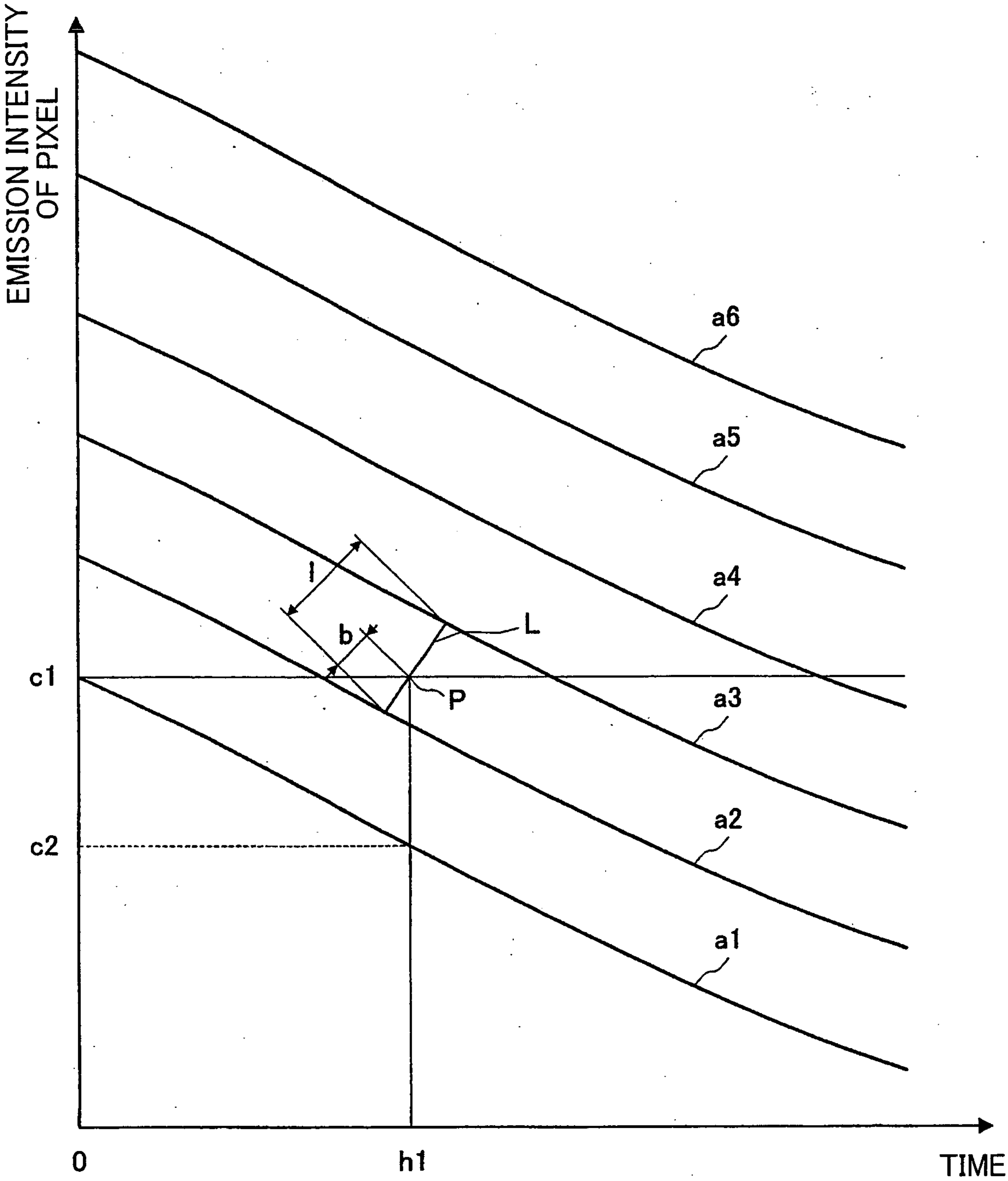
EMISSION INTENSITY OF PIXEL
a6
a5
a4
a3
a2
a1
l
b
L
P
c1
c2
0
h1
TIME

FIG. 23

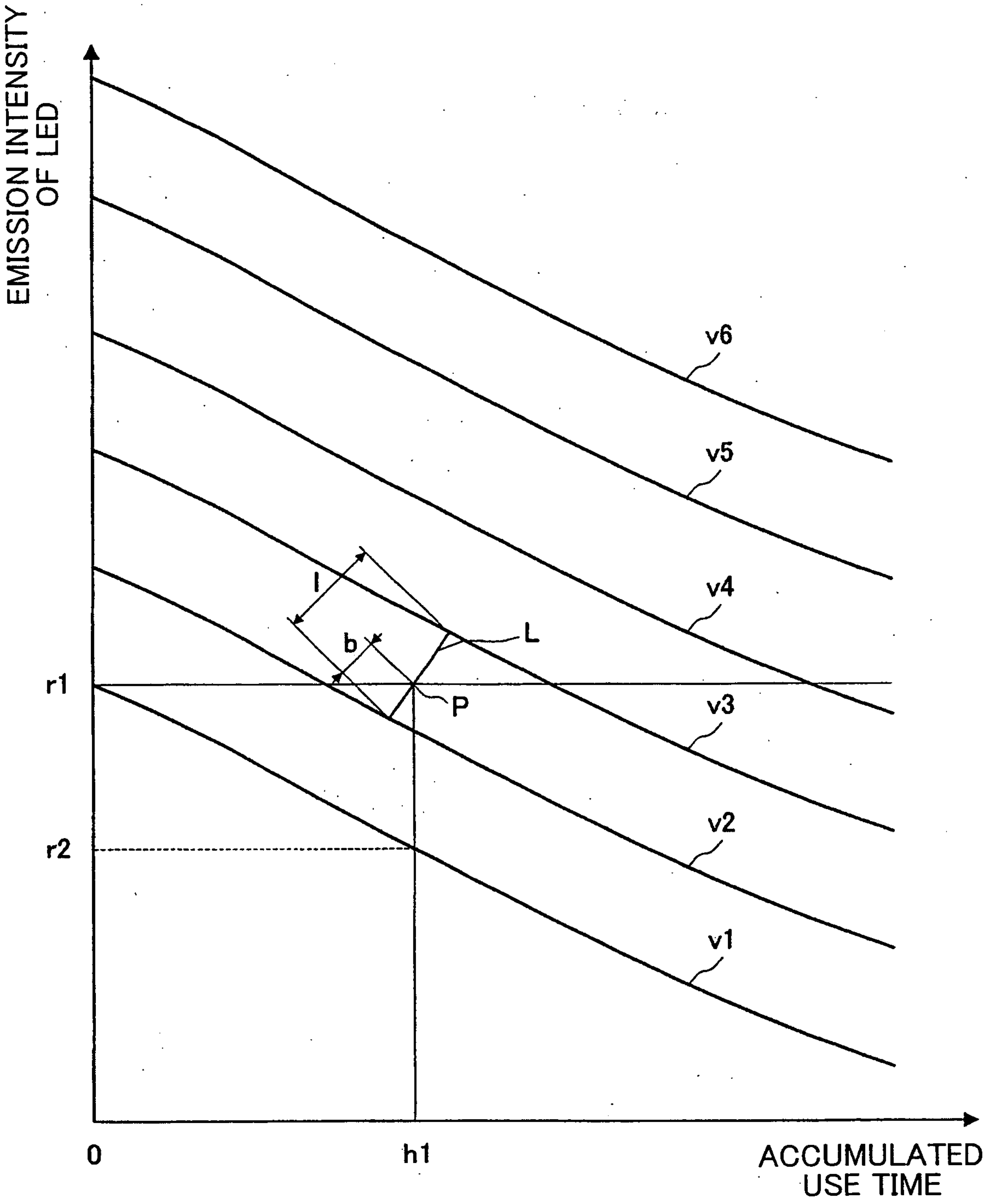
EMISSION INTENSITY OF LED
v6
v5
v4
l
L
b
r1
P
v3
v2
r2
v1
0
h1
ACCUMULATED USE TIME

## INTERNATIONAL SEARCH REPORT

International application No.
PCT/JP2007/068400

A. CLASSIFICATION OF SUBJECT MATTER
*G01B11/24*(2006.01)i, *B23K1/00*(2006.01)i, *G01N21/956*(2006.01)i, *H05K3/34*(2006.01)i

According to International Patent Classification (IPC) or to both national classification and IPC

B. FIELDS SEARCHED

Minimum documentation searched (classification system followed by classification symbols)
G01B11/00-30, B23K1/00, G01N21/84-958, H05K3/32-34

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 4-175649 A (Hitachi, Ltd.), 23 June, 1992 (23.06.92), Page 3, lower left column, line 20 to page 6, upper right column, line 15; Figs. 5 to 16 (Family: none) | 1-13,15,16, 19-22 |
| Y | JP 2005-140584 A (CKD Corp.), 02 June, 2005 (02.06.05), Par. Nos. [0027], [0028], [0039] to [0067]; Figs. 1 to 5 (Family: none) | 1-13,15,16, 19-22 |
| Y | JP 6-58729 A (Fujitsu Ltd.), 04 March, 1994 (04.03.94), Par. Nos. [0018] to [0029]; Figs. 1 to 8 (Family: none) | 1-13,15,16, 19-22 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 24 October, 2007 (24.10.07) | 06 November, 2007 (06.11.07) |
| Name and mailing address of the ISA/ Japanese Patent Office | Authorized officer |
| Facsimile No. | Telephone No. |

Form PCT/ISA/210 (second sheet) (April 2007)

**INTERNATIONAL SEARCH REPORT**

International application No.
PCT/JP2007/068400

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2003-17899 A (Sanyo Electric Co., Ltd.), 17 January, 2003 (17.01.03), Par. Nos. [0030] to [0034]; Fig. 4 (Family: none) | 12,13,15,16, 19-22 |
| Y | JP 2005-17123 A (Toshiba Corp.), 20 January, 2005 (20.01.05), Par. Nos. [0008] to [0049]; Figs. 1 to 5 (Family: none) | 12,13,15,16, 19-22 |
| A | JP 2005-337943 A (CKD Corp.), 08 December, 2005 (08.12.05), Full text; Figs. 1 to 9 (Family: none) | 1-22 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP H989536 B